# EUROPEAN PATENT APPLICATION

(11) **EP 2 065 390 A1**
(43) Date of publication of application: **03.06.2009**
(21) Application number: 07301611.5
(22) Date of filing: 30.11.2007
(51) Int. Cl.: C07F 7/00, C23C 16/30, C23C 16/34, C23C 16/40, C23C 16/42

(54) **Metal organic compounds containing an amidinate ligand and their use for vapour phase deposition of metal containing thin films**

(71) Applicant: L'AIR LIQUIDE, Société Anonyme pour l'Etude et l'Exploitation des Procédés Georges Claude, 75007 Paris (FR); Centre National de la Recherche Scientifique, 75794 Paris Cedex 16 (FR); UNIVERSITE CLAUDE BERNARD - LYON 1, 69622 Villeurbanne Cédex (FR)
(72) Inventor: Blasco, Nicolas, 92160, ANTONY (FR); Correia-Anacleto, Antony, 94700, MAISONS-ALFORT (FR); Lachaud, Christophe, 91240, SAINT MICHEL SUR ORGE (FR); Pinchart, Audrey, 91090, LISSES (FR); Maudez, William, 69100, VILLEURBANNE (FR); Eleter, Mohamad, 69100, VILLEURBANNE (FR); Daniele, Stéphane Jean, 69330, MEYZIEU (FR)
(74) Representative: Conan, Philippe Claude

(57) **Abstract**

Compound of the formula (I):

(R¹NC(R²)NR³)M(=NR⁴)_{y}[(NR⁵R⁶)z₁(NR⁷R⁸)z₂]

wherein,
y is an integer, y ≥ 1,
z₁ and z₂ are integers, z₁ ≥ 0 and z₂ ≥ 0,
and, 2y + z₁ + z₂ = 4;
M is a group V metal selected from Tantalum (Ta), Niobium (Nb) and Vanadium (V),
R¹, R², R³, R⁴, R⁵, R⁶, R⁷, and R⁸ which may be identical or different, are independently chosen from Hydrogen atom, linear or branched alkyl groups having from one to six carbon atoms, linear or branched alkoxy groups having from one to six carbon atoms, linear or branched alkylamide groups having from one to six carbon atoms, linear or branched alkylsilylamide groups having from one to six carbon atoms, linear or branched alkylsilyl groups having from one to six carbon atoms.

## Description

The invention relates to a new class or chemical compounds and their use in metal containing film deposition.

With the continuous shrink of the critical dimensions in the modern semiconductor devices, the introduction of new materials is drastically increasing. Tantalum, niobium and vanadium based materials are of particular interest for several main applications.

For instance, Group V (Ta, Nb, V) metal containing films find an application in back-end-of-the-line (BEOL) layers as metal diffusion barriers. In order to prevent the diffusion of copper among the circuits and ensure an adequate adhesion of the layer to silicon and to the low-k matrix, it is well acknowledged that a barrier layer such as Ta on TaN is needed. Nitrogen incorporation also helps to reduce the copper diffusion. Tantalum films are currently deposited using a sputter deposition method to achieve a low-k/TaN-Ta/Cu patterned structure or MOCVD processes. The required reduction of layer thickness and the incremental increase of structures aspect ratio, induce the need for search of new processes and new precursors for those processes..

Besides, group V (Ta, Nb, V) metal containing films are possible candidates to replace polysilicon as CMOS gate electrode. With the continuous scaling of devices, polydepletion contributes significantly to the CET. Besides that, Fermi level pinning occurs while using polysilicon on dielectric materials of high permitiviy (high-k's). By introducing metal gates the polydepletion is avoided and it is possible to obtain gates for PMOS and NMOS devices. The requirements for a suitable metal gate material generally include: lowest resistivity possible, thermal stability, good adhesion on the gate oxide, etch selectivity and suitable work-function. Ideally one would like two metal compounds with band-edge work-functions as ∼5.1eV for pMOS gate and ∼4.1eV for nMOS gate). Group V (Ta, Nb, V) metal containing films, and in particular tantalum based materials such as tantalum carbide, tantalum nitride, tantalum carbo-nitride, tantalum silicide, tantalum silico-carbide, tantalum silico-nitride, show promising properties for metal gate application. TaCN has been suggested as a suitable pMOS metal.

Besides, group V (Ta, Nb, V) metal containing films are used as electrodes (in the case of pure metal or metal nitride), and also as high-k layers (in the case of oxide) in the Metal-Insulator-Metal structures (DRAM...). For example, TaN and TaCₓN_{y} may be used for electrodes deposition, and Ta₂O₅ and TaOₓN_{y} for high-k layers.

The main industrial options to enable the deposition of such thin films with reasonable throughput and acceptable purity are vapor phase deposition techniques, such as MOCVD (Metal Organic Chemical Vapor Deposition) or ALD (Atomic Layer Deposition). For instance, ALD or Plasma-Assisted Atomic layer Deposition (PA-ALD or PEALD) is generally considered as a suitable method to form the highly conformal films needed for DRAM capacitors, when associated with a relevant precursor. Metal organic or halide compounds are required for those processes.

Many Group V (Ta, Nb, V) precursors have been considered to enable such deposition. Examples can be given as follows:
Halides such as TaCl₅ have been widely investigated such as described in US 6,268,288 by Hautala et al.. However, some by-products generated during the deposition process, such as HCl or Cl₂, can cause surface/interface roughness that can be detrimental to the final properties. Moreover, Cl or F impurities could be detrimental to the final electrical properties. It is therefore expected to find new compounds having sufficient volatility but without containing Cl, F, or Br atoms.

Alkylamides and alkylimides, such as Ta(NMe₂)₅ (PDMAT), Ta(=N^{t}Bu)(NEt₂)₃ (TBTDET), Ta(=NⁱPr)(NMe₂)₃ (IPTDMT), Ta(=NCH₂C(CH₃)₃)(NEt₂)₃ (TAIMATA), Ta(=NⁱPr)(NEt₂)₃ (IPTDET) have been considered. Those precursors present the advantages of being frequently liquid at room temperature, like TBTDET, and having fair volatility, sufficient shelf-life and thermal stability.

Urdahl et al. have also proposed TBTDET for the deposition of Ta₂O₅ in WO 02/20870.

TAIMATA has been first proposed by Yasuhara et al. in US 6,593,484.

A method of deposition of tantalum nitride films by sequential injection of TBTDET or TAIMATA and other N source is disclosed in US 2004/0219784.

A method and apparatus of generating PDMAT precursor has been proposed by Chen et al. in US 2004/0014320.

However, these precursors, and in particular the PDMAT, raise difficulties for the deposition of conductive TaN layers without assisting the thermal ALD process by plasma techniques. Moreover the use of these precursors to deposit Ta, TaC, TaSi films is not possible as they contain nitrogen which is always present in the deposited films. TBTDET and TAIMAT were used to deposit conductive tantalum nitride. However, this required the use of a plasma. It is acknowledged that plasma assisted deposition will face conformality limitations when used for 3 dimensional higher aspect ratio structures, resulting from the lifetime of the plasma radicals non-uniformity in the depth.

Guanidinates based precursors have also been proposed. Daniel Rische et al. reported in "Surface & Coatings Technology 201(2007) 9125-9130", tantalum guanidinate complexes synthesized according to literature, leading to the formation of compounds with the formula Ta(N^{t}Bu)(NR₂){(NⁱPr)₂CNR₂}₂. However, these compounds are generally high melting point solids and can not be easily vaporized to a reaction chamber. In addition, metal-organic compounds containing guanidinate usually present low thermal stability.

Today, there still exist the need for metal organic precursors having a high volatility in order to be in liquid state at room temperature (or close to room temperature) and having a high versatility, i.e. suitable for various applications in the semi-conductor manufacture such as metal gates, electrodes and/or high-k layer in Metal-Insulator-Metal structures for DRAM and/or copper diffusion barriers, or the like in TFT-LCD applications.

According to a first embodiment, the invention relates to a compound of the formula (I): (R¹NC(R²)NR³)M(=NR⁴)y[(NR⁵ R⁶)z₁(NR⁷ R⁸)z₂], wherein,
y is an integer, y ≥ 1, z₁ and z₂ are integers, z₁ ≥ 0 and z₂ ≥ 0,
and, 2y + z₁ + z₂ = 4;
M is a group V metal selected from Tantalum (Ta), Niobium (Nb) and Vanadium (V),
R¹, R², R³, R⁴, R⁵, R⁶, R⁷, and R⁸ which may be identical or different, are independently chosen from Hydrogen atom, linear or branched alkyl groups having from one to six carbon atoms, linear or branched alkoxy groups having from one to six carbon atoms, linear or branched alkylamide groups having from one to six carbon atoms, linear or branched alkylsilylamide groups having from one to six carbon atoms, linear or branched alkylsilyl groups having from one to six carbon atoms.

According to an embodiment, the invention relates to a compound of the formula (Ia) : 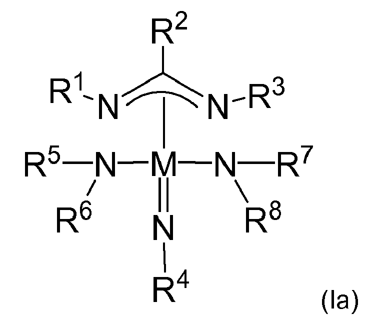 the formula (la) corresponding to formula (I) as defined above, wherein y=1 and z₁ = z₂ = 1.

According to another embodiment the invention relates to a compound of the formula (I) as defined above, wherein R¹ and R³, which may be identical or different, are independently chosen from linear or branched alkyl groups having from one to three carbon atoms.

According to another embodiment the invention relates to a compound of the formula (I) as defined above, wherein R¹ and R³, which may be identical or different, are independently chosen between methyl and ethyl.

According to another embodiment the invention relates to a compound of the formula (I) as defined above, wherein R¹ and R³, which may be identical or different, are independently chosen between isopropyl and tert-butyl.

According to another embodiment the invention relates to a compound of the formula (I) as defined above wherein R¹, R², and R³, are different from one another.

According to another embodiment the invention relates to a compound of the formula (I) as defined above, wherein R², is chosen from hydrogen and linear or branched alkyl groups having one to three carbon atoms.

According to another embodiment the invention relates to a compound of the formula (I) as defined above, wherein R², is chosen between hydrogen and methyl.

According to another embodiment the invention relates to a compound of the formula (I) as defined above, wherein R⁴, is chosen from linear or branched alkyl groups having three or four carbon atoms.

According to another embodiment the invention relates to a compound of the formula (I) as defined above, wherein R⁴, is chosen between isopropyl and tert-butyl.

According to another embodiment the invention relates to a compound of the formula (I) as defined above, wherein R⁵, R⁶, R⁷, and R⁸, which may be identical or different, are independently chosen from linear or branched alkyl groups having from one to three carbon atoms.

According to another embodiment the invention relates to a compound of the formula (I) as defined above, wherein R⁵, R⁶, R⁷, and R⁸, which may be identical or different, are independently chosen from linear or branched alkyl groups having one or two carbon atoms.

According to another embodiment the invention relates to a compound of the formula (I) as defined above, wherein R⁵, R⁶, R⁷, and R⁸, which may be identical or different, are independently chosen between methyl and ethyl.

According to another embodiment the invention relates to a compound of the formula (I) as defined above, wherein R⁵, R⁶, R⁷, and R⁸, are different from one another.

According to another embodiment the invention relates to a compound of the formula (I) as defined above, selected from the following compounds:
(ⁱPrNC(Me)NⁱPr)Ta(=N^{t}Bu)(NEt₂)₂;
(ⁱPrNC(Me)NⁱPr)Ta(=N^{t}Bu)(NMe₂)₂ ;
(ⁱPrNC(Me)NⁱPr)Ta(=NⁱPr)(NEt₂)₂ ;
(ⁱPrNC(Me)NⁱPr)Ta(=NⁱPr)(NMe₂)₂ ;
(ⁱPrNC(H)NⁱPr)Ta(=N^{t}Bu)(NEt₂)₂;
(ⁱPrNC(H)NⁱPr)Ta(=N^{t}Bu)(NMe₂)₂ ;

Those new precursors are particularly suitable for Metal-Organic Chemical Vapor Deposition (MOCVD) and Atomic Layer Deposition (ALD), with or without plasma-assistance, for proper distribution at sufficient vapor pressure, self-limited ALD window, and deposition of the above-mentioned metal containing, including ternary or quaternary materials, by using one or a combination of co-reactants.

The compounds of the formula (I) alone or in mixture, are used to deposite films of various compositions (as disclosed herein after) using any well-known deposition method using vapor phase deposition, such as MOCVD (Metal Organic Chemical Vapor Deposition), ALD (atomic layer deposition) and any other deposition method such as PECVD (plasma enhanced chemical vapor deposition) or as pulsed CVD. These new groop V metal precursors are thus useful for pure metal, metallic oxide, oxynitride, nitride and/or silicide film deposition to make electrodes and/or high k layers, and/or copper diffusion barrier layers and the like. In the ALD process the preferred temperature is in the range of 150 to 400°C, more preferably 200 to 350°C, the preferred pulse duration in ALD is 1 s and the preferred pressure is in the range of 0.1 Torr to 500 Torr, more preferably from 1 Torr to 100Torr.

In the CVD process, the preferred temperature is in the range of 200°C to 700°C, more preferably from 300°C to 500°C, the preferred pressure is in the range of 0.1 Torr to 500Torr, preferably from 1 Torr to 100 Torr and the preferred carrier gas is selected from N₂, He, Ar, H₂, more preferably Ar or N₂. The preferred N₂ canister flow is in the 30-200 sccm range, preferably 50 to 100 sccm.

In the PEALD process, the preferred temperature is in the range of 200°C to 700°C, more preferably from 300°C to 500°C, the preferred pressure is in the range of 0.001 Torr to 500Torr, preferably from 1 Torr to 100Torr, the preferred carrier gas is selected from N₂, He, Ar, H₂, more preferably Ar or N₂ and the preferred N₂ canister flow is in the 30 - 200 sccm range, preferably 50 to 100 sccm. H or NH radicals are produced by a remote plasma system and used as co-reactant.

In these above mentioned uses, any of the compound of the formula (I) as defined above, can be used alone or in mixture with one or several other compounds of the said formulas (I) and/or with any appropriate additive which are useful when depositing a metal containing film as provided hereafter.

Various films can be obtained on a substrate by using the precursors described here above, such as for example nitrides (MNₓ), carbides (MCₓ), silicides (MSiₓ), carbo-nitride (MCₓN_{y}), silico-carbide (MC_{y}Si_{z}), nitro-silicides (MSiₓN_{y}), carbo-nitro-silicide (MCₓNySiₓ), oxydes (e.g. MOₓ), oxynitrides (MOₓN_{y}), oxycarbo-nitride (MOₓNyC_{z}), silicates (MOₓSi_{y}), silico-nitrides (MOₓN_{y}Si_{z}), silico-carbo-nitride (MC_{w}OₓN_{y}Si_{z}) and oxynitrides from two or more different metals or elements M₁ and M₂ (M¹M²OₓN_{y}) or (M¹.....M^{t}OₓN_{y}), t being an integer from 3 to 6 and any combination of above materials; and x, y, z may be identical or different, being independently chosen from real numbers comprised between 0 and 10, particularly between 0 and 5 and more particularly between 0 and 4.

According to another embodiment, the invention relates to a process for forming a group V metal-containing film comprising the steps of:
a. Vaporizing a metal source containing at least one of the compounds described above to form a gas-phase metal source;
b. Feeding a plurality of precursors in vapor phase to a deposition device,
wherein said precursors comprise at least one said vaporized metal source; and forming a metallic or dielectric film, wherein said metallic or dielectric film is formed with the desired final composition.

The invention also relates to a process for depositing a group V metal containing film on a substrate comprising the steps of:
- introducing a substrate into a reactor,
- heating the substrate at a temperature preferably above 150°C;
- feeding at least one compound of the formula (I) as disclosed herein before or of a mixture of said compounds thereof in the vapor phase into the reactor;
- optionally feeding at least another precursor in vapor phase into the reactor;
- depositing a film containing at least one of said group V metal. If pure metal needs to be deposited onto the surface of the substrate, then no second precursor injection is needed.

However, if a film of nitride, carbide, silicide, nitro-silicide, oxyde, oxynitrides or the like is needed, then such second precursor injection may be necessary, providing the adequate species to obtain the final desired composition of the film.
TaNₓ: preferred reactants are NH₃, N₂H₄, methylhydrazine or mixture of them, or radicals produced from them or mixtures of them; TaSiₓ: preferred second precursor is SiH₄ or trisilane, hexadisilane, hexachlorodisilane or mixture of them;
TaSiₓN_{y}: preferred second precursor is TSA and NH₃, TriDMAS, tetraDMAS,
SAM.24, or mixture of them, possibly with NH₃ addition;
TaOₓ: preferred oxygen source is O₂, H₂O,or O₃ or mixture of them, or radicals produced from them or mixtures of them;
TaHfₓO_{y}: preferred second precursor is TEMAH;
TaCₓ: preferred second precursor is C₂H₄.or CₓH_{y;} and x, y may be identical or different, being independently chosen from real numbers comprised between 0 and 10, particularly between 0 and 5 and more particularly between 0 and 4.

According to another embodiment, the invention relates to a process as described above for depositing a TaⱼXᵢX'ₖ layer on a substrate, j is an integer equal to 1 or 2, i and k are integers comprised between 0 and 5, X and X' being selected from N and O, further comprising the step of injecting a X comprising reactant and/or a X' comprising reactant.

According to another embodiment, the invention relates to a process as described above for depositing a TaY layer on a substrate, Y being selected from Si, Hf, and C, further comprising the step of feeding a Y containing precursor.

According to another embodiment, the invention relates to a process as described above for depositing a TaXY layer on a substrate, X being selected from N and O, and Y being selected from Si, Hf, and C, further comprising the step of injecting a X comprising reactant and the step of feeding a Y containing precursor. The layer might contain oxygen resulting from post-deposition tantalum oxidation. The process according to the invention may be summarized as follows:

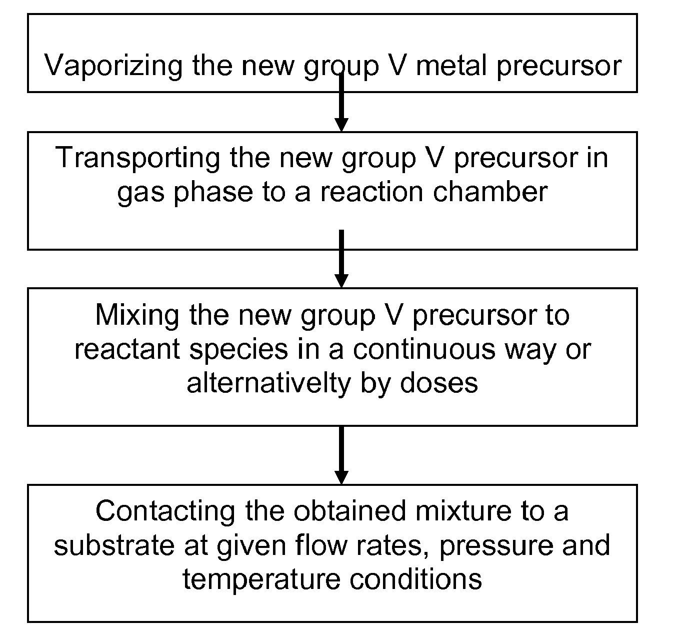

In one embodiment of the invention, the vaporization of the new metal source is realized by introducing a carrier gas into a heated container containing the said new metal source. The container is preferably heated at a temperature allowing to get the said metal source in liquid phase and at a sufficient vapor pressure. The carrier gas can be selected, without limitation, from Ar, He, H₂, N₂ or mixtures of them. The said metal source can be mixed to a solvant or to another metal source or to a mixture of them in the container. The container can for instance be heated at temperatures in the range of 25-200°C. Those skilled in the art will consider that the temperature of the container can be adjusted to control the amount of precursor vaporized. To control the evaporation level in the container, the pressure in the container can be modified. By reducing the pressure in the container the level of vaporation of the new metal source can be increased. The pressure in the container can for instance be changed in the range of 1mTorr till 800 Torr.

In another embodiment of the invention, the said metal source is fed in liquid state to a vaporizer where it is vaporized. The said metal source can be mixed to a solvent. The said metal source can be mixed to another metal source. The said mixture of metal sources can be mixed to a solvent or a mixture of solvent. The said metal source can be mixed to a stabilizer. The said solvent can be selected without limitation in the group consisting of alcanes such as hexane, heptane, octane, aromatic solvents such as benzene, toluene, mesitylene, xylene, silicon containing solvent such as hexamethyldisiloxane, hexamethyldisilazane, tetramethylsilane, sulphur containing solvents such as dimethylsulfoxide, oxygen containing solvent such as tetrahydrofuran, dioxane. The solvent might be selected to match the metal-organic evaporation characteristics in or before the vaporizer.

The vaporized metal source is there after introduced into a reaction chamber where it is contacted to a substrate. The substrate can be heated to a sufficient temperature to obtain the desired film at sufficient growth rate and with desired physical state and composition. Typical temperature range from 150°C to 600°C. Preferably the temperature is lower or equal to 450°C. The pressure in the reaction chamber is controlled to obtain the desired metal containing film at sufficient growth rate. Typical pressure range from 1 mTorr level to 100Torr or higher. In a specific embodiment, the pressure can be set at atmospheric pressure level or higher.

In one embodiment of the invention, the metal source is mixed to reactant species prior to the reaction chamber.

In another embodiment of the invention, the metal source is mixed to reactant species in the reaction chamber.

In another embodiment of the invention, the said metal source and the reactant species are introduced sequentially in the reaction chamber. The said metal source and reactant species can be introduced simultaneously (Metal Organic Chemical Vapor Deposition), sequentially (Atomic Layer Deposition) or different combinations (one example is to introduce metal source and the other metal source together in one pulse and ammonia in a separate pulse [modified Atomic Layer Deposition]); another example is to introduce ammonia continuously and to introduce metal source by pulse (Pulsed-Chemical Vapor Deposition).

In one embodiment of the invention, reactant species are passed through a plasma system localized remotely from the reaction chamber, and decomposed to radicals.

In one embodiment, the plasma source is turned off during the introduction of the said metal-organic compound and the reactant species are introduced continuously.

In another embodiment, the plasma source is turned off during the introduction of the said metal-organic compound, and the reactant species are not introduced during this said introduction.

In one embodiment of the invention where the targeted metal based film contains oxygen, such as for example without limitation metal oxide or metal oxy-nitride, the said reactant species include an oxygen source which is selected from, but not limited to, oxygen (O₂), oxygen radicals (for instance O. or OH.), for instance generated by a remote plasma, ozone (O₃), NO, N₂O, NO₂, water (H₂O) or H₂O₂.

In one embodiment of the invention where the targeted metal based film contains nitrogen, such as for example without limitation metal nitride or metal carbo-nitride, the said reactant species include a nitrogen source which is selected from, but not limited to, nitrogen (N₂), ammonia, hydrazine and alkyl derivatives, N-containing radicals (for instance N·, NH·, NH₂·), NO, N₂O, NO₂, amines.

In one embodiment of the invention where the targeted metal based film contains carbon, such as for example without limitation metal carbide or metal carbo-nitride, the said reactant species include a carbon source which is selected from, but not limited to, methane, ethane, propane, butane, ethylene, propylene, t-butylene, isobutylene, CCI₄.

In one embodiment of the invention where the targeted metal based film contains silicon, such as for example without limitation metal silicide, silico-nitride, silicate, silico-carbo-nitride, the said reactant species include a silicon source which is selected from, but not limited to, SiH₄, Si₂H₆, Si₃H₈, TriDMAS, BDMAS, BDEAS, TDEAS, TDMAS, TEMAS, (SiH₃)₃N, (SiH₃)₂O, trisilylamine, disiloxane, trisilylamine, disilane, trisilane, a alkoxysilane SiHₓ(OR¹)₄₋ₓ, a silanol Si(OH)ₓ(OR¹)₄₋ₓ (preferably Si(OH)(OR¹)₃; more preferably Si(OH)(O^{t}Bu)₃, an aminosilane SiHₓ(NR¹R²)₄₋ₓ (where x is comprised between 0 and 4; R¹ and R² are independently H or a C1-C6 carbon chain, either linear, branched or cyclic; preferably TriDMAS SiH(NMe₂)₃, BTBAS SiH₂(NH^{t}Bu)₂), BDEAS SiH₂(NEt₂)₂) and mixtures thereof. The targeted film can alternatively contain Germanium. The above-mentioned Si containing sources could be replaced by Ge containing sources.

In one embodiment of the invention, the metal source is mixed to another metal source to deposit a multi-metal containing film. The said metal sources may be simultaneously introduced and mixed into the reaction chamber. In another embodiment of the invention, the said metal sources are simultaneously introduced and mixed to reactant species into the reaction chamber. In another embodiment of the invention, the said metal sources are sequentially introduced with reactant species into the reaction chamber.

In another embodiment of the invention, the first metal source, the said metal source and reactant species are introduced sequentially in the reaction chamber. The said metal source and reactant species can be introduced simultaneously (Metal Organic Chemical Vapor Deposition), sequentially (Atomic Layer Deposition) or different combinations (one example is to introduce metal source and the other metal source together in one pulse and oxygen in a separate pulse [modified Atomic Layer Deposition]); another example is to introduce oxygen continuously and to introduce metal source by pulse (Pulsed-Chemical Vapor Deposition). In this embodiment, the purge gas can be selected without limitation in the list consisting of N₂, Ar, He or any other inert gas or mixture of them.

In one embodiment of the invention, the second metal source shall be selected from the group comprising a lanthanide and rare-earth metal source (Sc, Y, La, Ce, Pr, Nd, Gd...) source and is selected, but not limited to, from the group consisting of rare earth diketonates Ln(-O-C(R¹)-C(R²)-C(R³)-O-)(-O-C(R⁴)-C(R⁵)-C(R⁶)-O-)(-O-C(R⁷)-C(R⁸)-C(R⁹)-O-) (where each Rⁱ is independently H or a C1-C6 carbon chain, either linear, branched or cyclic), a cyclopentadienyl Ln(R¹Cp)(R²Cp)(R³Cp) (where each Rⁱ is independently H or a C1-C6 carbon chain, either linear, branched or cyclic), Ln(NR¹R²)(NR³R⁴)(NR⁵R⁶) and mixtures thereof. The other metal source can alternatively be an aluminum source and is selected from, but not limited to, the group consisting of trimethylaluminum, dimethylaluminum hydride, an alkoxyalane AlRⁱₓ(OR')₃₋ₓ (where x is comprised between 0 and 3; R¹ and R² are independently H or a C1-C6 carbon chain, either linear, branched or cyclic; preferably AlR¹R²(OR'), most preferably AlMe₂(OⁱPr)), an amidoalane AlRⁱₓ(NR'R")₃₋ₓ (where x is comprised between 0 and 3; R¹ and R² are independently H or a C1-C6 carbon chain, either linear, branched or cyclic) and mixtures thereof. The other metal source can alternatively be a tungsten, molybdenum source. The other metal source can alternatively be a hafnium, zirconium or titanium source such as M(OR¹)₄ or other alkoxide-containing metal sources, M(NR¹R²)₄, or adducts containing these species. The second metal source can alternatively be a divalent metal source (preferably Mg, Ca, Zn) selected from, but not limited to metal β-diketonates or adducts containing these species.

In one embodiment, the reactants can be introduced simultaneously (Metal Organic Chemical Vapor Deposition), sequentially (Atomic Layer Deposition) or different combinations (one example is to introduce metal source and the other metal source together in one pulse and oxygen in a separate pulse [modified Atomic Layer Deposition]); another example is to introduce oxygen continuously and to introduce metal source by pulse (Pulsed-Chemical Vapor Deposition).

In another embodiment of the invention, two or more metal-organic compounds of the present invention can be mixed altogether to provide a precursor mixture containing the two or more compounds. Alternatively, ligand exchange could occur in the so obtained precursor mixture to provide a third metal-organic precursor mixture. In this embodiment, the two or more metal-organic compounds of the present invention could alternatively be mixed together in an organic solvent chosen in the group consisting in C1-C8 alkanes, alcenes, aromatic solvents. In this embodiment, the obtained mixture can be delivered in liquid phase to a vaporizer. Alternatively, the obtained mixture can be delivered in gaz phase to the reactor chamber.

Below are given some examples without limitations of the new group V metal compounds having the feature of containing one amidinate ligand.

### Example 1: group V metal compounds:

Examples of compounds of the new family (R¹NC(R¹)NR¹)M(=NR²)(NR³₂)₂. Below are given some examples without limitations of the new group V metal compounds having the feature of containing one amidinate ligand. (MeNC(H)NMe)Ta(=NⁱPr)(NMe₂)₂, (MeNC(H)NEt)Ta(=NⁱPr)(NMe₂)₂, (MeNC(H)NⁱPr)Ta(=NⁱPr)(NMe₂)₂, (MeNC(H)N^{t}Bu)Ta(=NⁱPr)(NMe₂)₂, (MeNC(Me)NMe)Ta(=NⁱPr)(NMe₂)₂, (MeNC(Me)NEt)Ta(=NⁱPr)(NMe₂)₂, (MeNC(Me)NⁱPr)Ta(=NⁱPr)(NMe₂)₂, (MeNC(Me)N^{t}Bu)Ta(=NⁱPr)(NMe₂)₂, (MeNC(Et)NMe)Ta(=NⁱPr)(NMe₂)₂, (MeNC(Et)NEt)Ta(=NⁱPr)(NMe₂)₂, (MeNC(Et)NⁱPr)Ta(=NⁱPr)(NMe₂)₂, (MeNC(Et)N^{t}Bu)Ta(=NⁱPr)(NMe₂)₂, (MeNC(ⁱPr)NMe)Ta(=NⁱPr)(NMe₂)₂, (MeNC(ⁱPr)NEt)Ta(=NⁱPr)(NMe₂)₂, (MeNC(ⁱPr)NⁱPr)Ta(=NⁱPr)(NMe₂)₂, (MeNC(ⁱPr)N^{t}Bu)Ta(=NⁱPr)(NMe₂)₂, (MeNC(^{t}Bu)NMe)Ta(=NⁱPr)(NMe₂)₂, (MeNC(^{t}Bu)NEt)Ta(=NⁱPr)(NMe₂)₂, (MeNC(^{t}Bu)NⁱPr)Ta(=NⁱPr)(NMe₂)₂, (MeNC(^{t}Bu)N^{t}Bu)Ta(=NⁱPr)(NMe₂)₂, (EtNC(H)NEt)Ta(=NⁱPr)(NMe₂)₂, (EtNC(H)NⁱPr)Ta(=NⁱPr)(NMe₂)₂, (EtNC(H)N^{t}Bu)Ta(=NⁱPr)(NMe₂)₂, (EtNC(Me)NEt)Ta(=NⁱPr)(NMe₂)₂, (EtNC(Me)NⁱPr)Ta(=NⁱPr)(NMe₂)₂, (EtNC(Me)N^{t}Bu)Ta(=NⁱPr)(NMe₂)₂, (EtNC(Et)NEt)Ta(=NⁱPr)(NMe₂)₂, (EtNC(Et)NⁱPr)Ta(=NⁱPr)(NMe₂)₂, (EtNC(Et)N^{t}Bu)Ta(=NⁱPr)(NMe₂)₂, (EtNC(ⁱPr)NEt)Ta(=NⁱPr)(NMe₂)₂, (EtNC(ⁱPr)NⁱPr)Ta(=NⁱPr)(NMe₂)₂, (EtNC(ⁱPr)N^{t}Bu)Ta(=NⁱPr)(NMe₂)₂, (EtNC(^{t}Bu)NEt)Ta(=NⁱPr)(NMe₂)₂, (EtNC(^{t}Bu)NⁱPr)Ta(=NⁱPr)(NMe₂)₂, (EtNC(^{t}Bu)N^{t}Bu)Ta(=NⁱPr)(NMe₂)₂, (ⁱPrNC(H)NⁱPr)Ta(=NⁱPr)(NMe₂)₂, (ⁱPrNC(H)N^{t}Bu)Ta(=NⁱPr)(NMe₂)₂, (ⁱPrNC(Me)NⁱPr)Ta(=NⁱPr)(NMe₂)₂, (ⁱPrNC(Me)N^{t}Bu)Ta(=NⁱPr)(NMe₂)₂, (ⁱPrNC(Et)NⁱPr)Ta(=NⁱPr)(NMe₂)₂, (ⁱPrNC(Et)N^{t}Bu)Ta(=NⁱPr)(NMe₂)₂, (ⁱPrNC(ⁱPr)NⁱPr)Ta(=NⁱPr)(NMe₂)₂, (ⁱPrNC(ⁱPr)N^{t}Bu)Ta(=NⁱPr)(NMe₂)₂, (ⁱPrNC(^{t}Bu)NⁱPr)Ta(=NⁱPr)(NMe₂)₂, (ⁱPrNC(^{t}Bu)N^{t}Bu)Ta(=NⁱPr)(NMe₂)₂, (^{t}BuNC(H)N^{t}Bu)Ta(=NⁱPr)(NMe₂)₂, (^{t}BuNC(Me)N^{t}Bu)Ta(=NⁱPr)(NMe₂)₂, (^{t}BuNC(Et)N^{t}Bu)Ta(=NⁱPr)(NMe₂)₂, (^{t}BuNC(ⁱPr)N^{t}Bu)Ta(=NⁱPr)(NMe₂)₂, (^{t}BuNC(^{t}Bu)N^{t}Bu)Ta(=NⁱPr)(NMe₂)₂, (MeNC(H)NMe)Ta(=NⁱPr)(NMeEt)₂, (MeNC(H)NEt)Ta(=NⁱPr)(NMeEt)₂, (MeNC(H)NⁱPr)Ta(=NⁱPr)(NMeEt)₂, (MeNC(H)N^{t}Bu)Ta(=NⁱPr)(NMeEt)₂, (MeNC(Me)NMe)Ta(=NⁱPr)(NMeEt)₂, (MeNC(Me)NEt)Ta(=NⁱPr)(NMeEt)₂, (MeNC(Me)NⁱPr)Ta(=NⁱPr)(NMeEt)₂, (MeNC(Me)N^{t}Bu)Ta(=NⁱPr)(NMeEt)₂, (MeNC(Et)NMe)Ta(=NⁱPr)(NMeEt)₂, (MeNC(Et)NEt)Ta(=NⁱPr)(NMeEt)₂, (MeNC(Et)NⁱPr)Ta(=NⁱPr)(NMeEt)₂, (MeNC(Et)N^{t}Bu)Ta(=NⁱPr)(NMeEt)₂, (MeNC(ⁱPr)NMe)Ta(=NⁱPr)(NMeEt)₂, (MeNC(ⁱPr)NEt)Ta(=NⁱPr)(NMeEt)₂, (MeNC(ⁱPr)NⁱPr)Ta(=NⁱPr)(NMeEt)₂, (MeNC(ⁱPr)N^{t}Bu)Ta(=NⁱPr)(NMeEt)₂, (MeNC(^{t}Bu)NMe)Ta(=NⁱPr)(NMeEt)₂, (MeNC(^{t}Bu)NEt)Ta(=NⁱPr)(NMeEt)₂, (MeNC(^{t}Bu)NⁱPr)Ta(=NⁱPr)(NMeEt)₂, (MeNC(^{t}Bu)N^{t}Bu)Ta(=NⁱPr)(NMeEt)₂, (EtNC(H)NEt)Ta(=NⁱPr)(NMeEt)₂, (EtNC(H)NⁱPr)Ta(=NⁱPr)(NMeEt)₂, (EtNC(H)N^{t}Bu)Ta(=NⁱPr)(NMeEt)₂, (EtNC(Me)NEt)Ta(=NⁱPr)(NMeEt)₂, (EtNC(Me)NⁱPr)Ta(=NⁱPr)(NMeEt)₂, (EtNC(Me)N^{t}Bu)Ta(=NⁱPr)(NMeEt)₂, (EtNC(Et)NEt)Ta(=NⁱPr)(NMeEt)₂, (EtNC(Et)NⁱPr)Ta(=NⁱPr)(NMeEt)₂, (EtNC(Et)N^{t}Bu)Ta(=NⁱPr)(NMeEt)₂, (EtNC(ⁱPr)NEt)Ta(=NⁱPr)(NMeEt)₂, (EtNC(ⁱPr)NⁱPr)Ta(=NⁱPr)(NMeEt)₂, (EtNC(ⁱPr)N^{t}Bu)Ta(=NⁱPr)(NMeEt)₂, (EtNC(^{t}Bu)NEt)Ta(=NⁱPr)(NMeEt)₂, (EtNC(^{t}Bu)NⁱPr)Ta(=NⁱPr)(NMeEt)₂, (EtNC(^{t}Bu)N^{t}Bu)Ta(=NⁱPr)(NMeEt)₂, (ⁱPrNC(H)NⁱPr)Ta(=NⁱPr)(NMeEt)₂, (ⁱPrNC(H)N^{t}Bu)Ta(=NⁱPr)(NMeEt)₂, (ⁱPrNC(Me)NⁱPr)Ta(=NⁱPr)(NMeEt)₂, (ⁱPrNC(Me)N^{t}Bu)Ta(=NⁱPr)(NMeEt)₂, (ⁱPrNC(Et)NⁱPr)Ta(=NⁱPr)(NMeEt)₂, (ⁱPrNC(Et)N^{t}Bu)Ta(=NⁱPr)(NMeEt)₂, (ⁱPrNC(ⁱPr)NⁱPr)Ta(=NⁱPr)(NMeEt)₂, (ⁱPrNC(ⁱPr)N^{t}Bu)Ta(=NⁱPr)(NMeEt)₂, (ⁱPrNC(^{t}Bu)NⁱPr)Ta(=NⁱPr)(NMeEt)₂, (ⁱPrNC(^{t}Bu)N^{t}Bu)Ta(=NⁱPr)(NMeEt)₂, (^{t}BuNC(H)N^{t}Bu)Ta(=NⁱPr)(NMeEt)₂, (^{t}BuNC(Me)N^{t}Bu)Ta(=NⁱPr)(NMeEt)₂, (^{t}BuNC(Et)N^{t}Bu)Ta(=NⁱPr)(NMeEt)₂, (^{t}BuNC(ⁱPr)N^{t}Bu)Ta(=NⁱPr)(NMeEt)₂, (^{t}BuNC(^{t}Bu)N^{t}Bu)Ta(=NⁱPr)(NMeEt)₂, (MeNC(H)NMe)Ta(=NⁱPr)(NEt₂)₂, (MeNC(H)NEt)Ta(=NⁱPr)(NEt₂)₂, (MeNC(H)NⁱPr)Ta(=NⁱPr)(NEt₂)₂, (MeNC(H)N^{t}Bu)Ta(=NⁱPr)(NEt₂)₂, (MeNC(Me)NMe)Ta(=NⁱPr)(NEt₂)₂, (MeNC(Me)NEt)Ta(=NⁱPr)(NEt₂)₂, (MeNC(Me)NⁱPr)Ta(=NⁱPr)(NEt₂)₂, (MeNC(Me)N^{t}Bu)Ta(=NⁱPr)(NEt₂)₂, (MeNC(Et)NMe)Ta(=NⁱPr)(NEt₂)₂, (MeNC(Et)NEt)Ta(=NⁱPr)(NEt₂)₂, (MeNC(Et)NⁱPr)Ta(=NⁱPr)(NEt₂)₂, (MeNC(Et)N^{t}Bu)Ta(=NⁱPr)(NEt₂)₂, (MeNC(ⁱPr)NMe)Ta(=NⁱPr)(NEt₂)₂, (MeNC(ⁱPr)NEt)Ta(=NⁱPr)(NEt₂)₂, (MeNC(ⁱPr)NⁱPr)Ta(=NⁱPr)(NEt₂)₂, (MeNC(ⁱPr)N^{t}Bu)Ta(=NⁱPr)(NEt₂)₂, (MeNC(^{t}Bu)NMe)Ta(=NⁱPr)(NEt₂)₂, (MeNC(^{t}Bu)NEt)Ta(=NⁱPr)(NEt₂)₂, (MeNC(^{t}Bu)NⁱPr)Ta(=NⁱPr)(NEt₂)₂, (MeNC(^{t}Bu)N^{t}Bu)Ta(=NⁱPr)(NEt₂)₂, (EtNC(H)NEt)Ta(=NⁱPr)(NEt₂)₂, (EtNC(H)NⁱPr)Ta(=NⁱPr)(NEt₂)₂, (EtNC(H)N^{t}Bu)Ta(=NⁱPr)(NEt₂)₂, (EtNC(Me)NEt)Ta(=NⁱPr)(NEt₂)₂, (EtNC(Me)NⁱPr)Ta(=NⁱPr)(NEt₂)₂, (EtNC(Me)N^{t}Bu)Ta(=NⁱPr)(NEt₂)₂, (EtNC(Et)NEt)Ta(=NⁱPr)(NEt₂)₂, (EtNC(Et)NⁱPr)Ta(=NⁱPr)(NEt₂)₂, (EtNC(Et)N^{t}Bu)Ta(=NⁱPr)(NEt₂)₂, (EtNC(ⁱPr)NEt)Ta(=NⁱPr)(NEt₂)₂, (EtNC(ⁱPr)NⁱPr)Ta(=NⁱPr)(NEt₂)₂, (EtNC(ⁱPr)N^{t}Bu)Ta(=NⁱPr)(NEt₂)₂, (EtNC(^{t}Bu)NEt)Ta(=NⁱPr)(NEt₂)₂, (EtNC(^{t}Bu)NⁱPr)Ta(=NⁱPr)(NEt₂)₂, (EtNC(^{t}Bu)N^{t}Bu)Ta(=NⁱPr)(NEt₂)₂, (ⁱPrNC(H)NⁱPr)Ta(=NⁱPr)(NEt₂)₂, (ⁱPrNC(H)N^{t}Bu)Ta(=NⁱPr)(NEt₂)₂, (ⁱPrNC(Me)NⁱPr)Ta(=NⁱPr)(NEt₂)₂, (ⁱPrNC(Me)N^{t}Bu)Ta(=NⁱPr)(NEt₂)₂, (ⁱPrNC(Et)NⁱPr)Ta(=NⁱPr)(NEt₂)₂, (ⁱPrNC(Et)N^{t}Bu)Ta(=NⁱPr)(NEt₂)₂, (ⁱPrNC(ⁱPr)NⁱPr)Ta(=NⁱPr)(NEt₂)₂, (ⁱPrNC(ⁱPr)N^{t}Bu)Ta(=NⁱPr)(NEt₂)₂, (ⁱPrNC(^{t}Bu)NⁱPr)Ta(=NⁱPr)(NEt₂)₂, (ⁱPrNC(^{t}Bu)N^{t}Bu)Ta(=NⁱPr)(NEt₂)₂, (^{t}BuNC(H)N^{t}Bu)Ta(=NⁱPr)(NEt₂)₂, (^{t}BuNC(Me)N^{t}Bu)Ta(=NⁱPr)(NEt₂)₂, (^{t}BuNC(Et)N^{t}Bu)Ta(=NⁱPr)(NEt₂)₂, (^{t}BuNC(ⁱPr)N^{t}Bu)Ta(=NⁱPr)(NEt₂)₂, (^{t}BuNC(^{t}Bu)N^{t}Bu)Ta(=NⁱPr)(NEt₂)₂, (MeNC(H)NMe)Ta(=NⁱPr)(NMe₂)(NEt₂), (MeNC(H)NEt)Ta(=NⁱPr)(NMe₂)(NEt₂), (MeNC(H)NᵢPr)Ta(=NᵢPr)(NMe₂)(NEt₂), (MeNC(H)N^{t}Bu)Ta(=NⁱPr)(NMe₂)(NEt₂), (MeNC(Me)NMe)Ta(=NⁱPr)(NMe₂)(NEt₂), (MeNC(Me)NEt)Ta(=NⁱPr)(NMe₂)(NEt₂), (MeNC(Me)NⁱPr)Ta(=NⁱPr)(NMe₂)(NEt₂), (MeNC(Me)N^{t}Bu)Ta(=NⁱPr)(NMe₂)(NEt₂), (MeNC(Et)NMe)Ta(=NⁱPr)(NMe₂)(NEt₂), (MeNC(Et)NEt)Ta(=NⁱPr)(NMe₂)(NEt₂), (MeNC(Et)NⁱPr)Ta(=NⁱPr)(NMe₂)(NEt₂), (MeNC(Et)N^{t}Bu)Ta(=NⁱPr)(NMe₂)(NEt₂), (MeNC(ⁱPr)NMe)Ta(=NⁱPr)(NMe₂)(NEt₂), (MeNC(ⁱPr)NEt)Ta(=NⁱPr)(NMe₂)(NEt₂), (MeNC(ⁱPr)NⁱPr)Ta(=NⁱPr)(NMe₂)(NEt₂), (MeNC(ⁱPr)N^{t}Bu)Ta(=NⁱPr)(NMe₂)(NEt₂), (MeNC(^{t}Bu)NMe)Ta(=NⁱPr)(NMe₂)(NEt₂), (MeNC(^{t}Bu)NEt)Ta(=NⁱPr)(NMe₂)(NEt₂), (MeNC(^{t}Bu)NⁱPr)Ta(=NⁱPr)(NMe₂)(NEt₂), (MeNC(^{t}Bu)N^{t}Bu)Ta(=NⁱPr)(NMe₂)(NEt₂), (EtNC(H)NEt)Ta(=NⁱPr)(NMe₂)(NEt₂), (EtNC(H)NⁱPr)Ta(=NⁱPr)(NMe₂)(NEt₂), (EtNC(H)N^{t}Bu)Ta(=NⁱPr)(NMe₂)(NEt₂), (EtNC(Me)NEt)Ta(=NⁱPr)(NMe₂)(NEt₂), (EtNC(Me)NⁱPr)Ta(=NⁱPr)(NMe₂)(NEt₂), (EtNC(Me)N^{t}Bu)Ta(=NⁱPr)(NMe₂)(NEt₂), (EtNC(Et)NEt)Ta(=NⁱPr)(NMe₂)(NEt₂), (EtNC(Et)NⁱPr)Ta(=NⁱPr)(NMe₂)(NEt₂), (EtNC(Et)N^{t}Bu)Ta(=NⁱPr)(NMe₂)(NEt₂), (EtNC(ⁱPr)NEt)Ta(=NⁱPr)(NMe₂)(NEt₂), (EtNC(ⁱPr)NⁱPr)Ta(=NⁱPr)(NMe₂)(NEt₂), (EtNC(ⁱPr)N^{t}Bu)Ta(=NⁱPr)(NMe₂)(NEt₂), (EtNC(^{t}Bu)NEt)Ta(=NⁱPr)(NMe₂)(NEt₂), (EtNC(^{t}Bu)NⁱPr)Ta(=NⁱPr)(NMe₂)(NEt₂), (EtNC(^{t}Bu)N^{t}Bu)Ta(=NⁱPr)(NMe₂)(NEt₂), (ⁱPrNC(H)NⁱPr)Ta(=NⁱPr)(NMe₂)(NEt₂), (ⁱPrNC(H)N^{t}Bu)Ta(=NⁱPr)(NMe₂)(NEt₂), (ⁱPrNC(Me)NⁱPr)Ta(=NⁱPr)(NMe₂)(NEt₂), (ⁱPrNC(Me)N^{t}Bu)Ta(=NⁱPr)(NMe₂)(NEt₂), (ⁱPrNC(Et)NⁱPr)Ta(=NⁱPr)(NMe₂)(NEt₂), (ⁱPrNC(Et)N^{t}Bu)Ta(=NⁱPr)(NMe₂)(NEt₂), (ⁱPrNC(ⁱPr)NⁱPr)Ta(=NⁱPr)(NMe₂)(NEt₂), (ⁱPrNC(ⁱPr)N^{t}Bu)Ta(=NⁱPr)(NMe₂)(NEt₂), (ⁱPrNC(^{t}Bu)NⁱPr)Ta(=NⁱPr)(NMe₂)(NEt₂), (ⁱPrNC(^{t}Bu)N^{t}Bu)Ta(=NⁱPr)(NMe₂)(NEt₂), (^{t}BuNC(H)N^{t}Bu)Ta(=NⁱPr)(NMe₂)(NEt₂), (^{t}BuNC(Me)N^{t}Bu)Ta(=NⁱPr)(NMe₂)(NEt₂), (^{t}BuNC(Et)N^{t}Bu)Ta(=NⁱPr)(NMe₂)(NEt₂), (^{t}BuNC(ⁱPr)N^{t}Bu)Ta(=NⁱPr)(NMe₂)(NEt₂), (^{t}BuNC(^{t}Bu)N^{t}Bu)Ta(=NⁱPr)(NMe₂)(NEt₂), (MeNC(H)NMe)Ta(=NⁱPr)(NMe₂)(NMeEt), (MeNC(H)NEt)Ta(=NⁱPr)(NMe₂)(NMeEt), (MeNC(H)NⁱPr)Ta(=NⁱPr)(NMe₂)(NMeEt), (MeNC(H)N^{t}Bu)Ta(=NⁱPr)(NMe₂)(NMeEt), (MeNC(Me)NMe)Ta(=NⁱPr)(NMe₂)(NMeEt), (MeNC(Me)NEt)Ta(=NⁱPr)(NMe₂)(NMeEt), (MeNC(Me)NⁱPr)Ta(=NⁱPr)(NMe₂)(NMeEt), (MeNC(Me)N^{t}Bu)Ta(=NⁱPr)(NMe₂)(NMeEt), (MeNC(Et)NMe)Ta(=NⁱPr)(NMe₂)(NMeEt), (MeNC(Et)NEt)Ta(=NⁱPr)(NMe₂)(NMeEt), (MeNC(Et)NⁱPr)Ta(=NⁱPr)(NMe₂)(NMeEt), (MeNC(Et)N^{t}Bu)Ta(=NⁱPr)(NMe₂)(NMeEt), (MeNC(ⁱPr)NMe)Ta(=NⁱPr)(NMe₂)(NMeEt), (MeNC(ⁱPr)NEt)Ta(=NⁱPr)(NMe₂)(NMeEt), (MeNC(ⁱPr)NⁱPr)Ta(=NⁱPr)(NMe₂)(NMeEt), (MeNC(ⁱPr)N^{t}Bu)Ta(=NⁱPr)(NMe₂)(NMeEt), (MeNC(^{t}Bu)NMe)Ta(=NⁱPr)(NMe₂)(NMeEt), (MeNC(^{t}Bu)NEt)Ta(=NⁱPr)(NMe₂)(NMeEt), (MeNC(^{t}Bu)NⁱPr)Ta(=NⁱPr)(NMe₂)(NMeEt), (MeNC(^{t}Bu)N^{t}Bu)Ta(=NⁱPr)(NMe₂)(NMeEt), (EtNC(H)NEt)Ta(=NⁱPr)(NMe₂)(NMeEt), (EtNC(H)NⁱPr)Ta(=NⁱPr)(NMe₂)(NMeEt), (EtNC(H)N^{t}Bu)Ta(=NⁱPr)(NMe₂)(NMeEt), (EtNC(Me)NEt)Ta(=NⁱPr)(NMe₂)(NMeEt), (EtNC(Me)NⁱPr)Ta(=NⁱPr)(NMe₂)(NMeEt), (EtNC(Me)N^{t}Bu)Ta(=NⁱPr)(NMe₂)(NMeEt), (EtNC(Et)NEt)Ta(=NⁱPr)(NMe₂)(NMeEt), (EtNC(Et)NⁱPr)Ta(=NⁱPr)(NMe₂)(NMeEt), (EtNC(Et)N^{t}Bu)Ta(=NⁱPr)(NMe₂)(NMeEt), (EtNC(ⁱPr)NEt)Ta(=NⁱPr)(NMe₂)(NMeEt), (EtNC(ⁱPr)NⁱPr)Ta(=NⁱPr)(NMe₂)(NMeEt), (EtNC(ⁱPr)N^{t}Bu)Ta(=NⁱPr)(NMe₂)(NMeEt), (EtNC(^{t}Bu)NEt)Ta(=NⁱPr)(NMe₂)(NMeEt), (EtNC(^{t}Bu)NⁱPr)Ta(=NⁱPr)(NMe₂)(NMeEt), (EtNC(^{t}Bu)N^{t}Bu)Ta(=NⁱPr)(NMe₂)(NMeEt), (ⁱPrNC(H)NⁱPr)Ta(=NⁱPr)(NMe₂)(NMeEt), (ⁱPrNC(H)N^{t}Bu)Ta(=NⁱPr)(NMe₂)(NMeEt), (ⁱPrNC(Me)NⁱPr)Ta(=NⁱPr)(NMe₂)(NMeEt), (ⁱPrNC(Me)N^{t}Bu)Ta(=NⁱPr)(NMe₂)(NMeEt), (ⁱPrNC(Et)NⁱPr)Ta(=NⁱPr)(NMe₂)(NMeEt), (ⁱPrNC(Et)N^{t}Bu)Ta(=NⁱPr)(NMe₂)(NMeEt), (ⁱPrNC(ⁱPr)NⁱPr)Ta(=NⁱPr)(NMe₂)(NMeEt), (ⁱPrNC(ⁱPr)N^{t}Bu)Ta(=NⁱPr)(NMe₂)(NMeEt), (ⁱPrNC(^{t}Bu)NⁱPr)Ta(=NⁱPr)(NMe₂)(NMeEt), (ⁱPrNC(^{t}Bu)N^{t}Bu)Ta(=NⁱPr)(NMe₂)(NMeEt), (^{t}BuNC(H)N^{t}Bu)Ta(=NⁱPr)(NMe₂)(NMeEt), (^{t}BuNC(Me)N^{t}Bu)Ta(=NⁱPr)(NMe₂)(NMeEt), (^{t}BuNC(Et)N^{t}Bu)Ta(=NⁱPr)(NMe₂)(NMeEt), (^{t}BuNC(ⁱPr)N^{t}Bu)Ta(=NⁱPr)(NMe₂)(NMeEt), (^{t}BuNC(^{t}Bu)N^{t}Bu)Ta(=NⁱPᵣ)(NMe₂)(NMeEt), (MeNC(H)NMe)Ta(=NⁱPr)(NEt₂)(NMeEt), (MeNC(H)NEt)Ta(=NⁱPr)(NEt₂)(NMeEt), (MeNC(H)NⁱPr)Ta(=NⁱPr)(NEt₂)(NMeEt), (MeNC(H)N^{t}Bu)Ta(=NⁱPr)(NEt₂)(NMeEt), (MeNC(Me)NMe)Ta(=NⁱPr)(NEt₂)(NMeEt), (MeNC(Me)NEt)Ta(=NⁱPr)(NEt₂)(NMeEt), (MeNC(Me)NⁱPr)Ta(=NⁱPr)(NEt₂)(NMeEt), (MeNC(Me)N^{t}Bu)Ta(=NⁱPr)(NEt₂)(NMeEt), (MeNC(Et)NMe)Ta(=NⁱPr)(NEt₂)(NMeEt), (MeNC(Et)NEt)Ta(=NⁱPr)(NEt₂)(NMeEt), (MeNC(Et)NⁱPr)Ta(=NⁱPr)(NEt₂)(NMeEt), (MeNC(Et)N^{t}Bu)Ta(=NⁱPr)(NEt₂)(NMeEt), (MeNC(ⁱPr)NMe)Ta(=NⁱPr)(NEt₂)(NMeEt), (MeNC(ⁱPr)NEt)Ta(=NⁱPr)(NEt₂)(NMeEt), (MeNC(ⁱPr)NⁱPr)Ta(=NⁱPr)(NEt₂)(NMeEt), (MeNC(ⁱPr)N^{t}Bu)Ta(=NⁱPr)(NEt₂)(NMeEt), (MeNC(^{t}Bu)NMe)Ta(=NⁱPr)(NEt₂)(NMeEt), (MeNC(^{t}Bu)NEt)Ta(=NⁱPr)(NEt₂)(NMeEt), (MeNC(^{t}Bu)NⁱPr)Ta(=NⁱPr)(NEt₂)(NMeEt), (MeNC(^{t}Bu)N^{t}Bu)Ta(=NⁱPr)(NEt₂)(NMeEt), (EtNC(H)NEt)Ta(=NⁱPr)(NEt₂)(NMeEt), (EtNC(H)NⁱPr)Ta(=NⁱPr)(NEt₂)(NMeEt), (EtNC(H)N^{t}Bu)Ta(=NⁱPr)(NEt₂)(NMeEt), (EtNC(Me)NEt)Ta(=NⁱPr)(NEt₂)(NMeEt), (EtNC(Me)NⁱPr)Ta(=NⁱPr)(NEt₂)(NMeEt), (EtNC(Me)N^{t}Bu)Ta(=NⁱPr)(NEt₂)(NMeEt), (EtNC(Et)NEt)Ta(=NⁱPr)(NEt₂)(NMeEt), (EtNC(Et)NⁱPr)Ta(=NⁱPr)(NEt₂)(NMeEt), (EtNC(Et)N^{t}Bu)Ta(=NⁱPr)(NEt₂)(NMeEt), (EtNC(ⁱPr)NEt)Ta(=NⁱPr)(NEt₂)(NMeEt), (EtNC(ⁱPr)NⁱPr)Ta(=NⁱPr)(NEt₂)(NMeEt), (EtNC(ⁱPr)N^{t}Bu)Ta(=NⁱPr)(NEt₂)(NMeEt), (EtNC(^{t}Bu)NEt)Ta(=NⁱPr)(NEt₂)(NMeEt), (EtNC(^{t}Bu)NⁱPr)Ta(=NⁱPr)(NEt₂)(NMeEt), (EtNC(^{t}Bu)N^{t}Bu)Ta(=NⁱPr)(NEt₂)(NMeEt), (ⁱPrNC(H)NⁱPr)Ta(=NⁱPr)(NEt₂)(NMeEt), (ⁱPrNC(H)N^{t}Bu)Ta(=NⁱPr)(NEt₂)(NMeEt), (ⁱPrNC(Me)NⁱPr)Ta(=NⁱPr)(NEt₂)(NMeEt), (ⁱPrNC(Me)N^{t}Bu)Ta(=NⁱPr)(NEt₂)(NMeEt), (ⁱPrNC(Et)NⁱPr)Ta(=NⁱPr)(NEt₂)(NMeEt), (ⁱPrNC(Et)N^{t}Bu)Ta(=NⁱPr)(NEt₂)(NMeEt), (ⁱPrNC(ⁱPr)NⁱPr)Ta(=NⁱPr)(NEt₂)(NMeEt), (ⁱPrNC(ⁱPr)N^{t}Bu)Ta(=NⁱPr)(NEt₂)(NMeEt), (ⁱPrNC(^{t}Bu)NⁱPr)Ta(=NⁱPr)(NEt₂)(NMeEt), (ⁱPrNC(^{t}Bu)N^{t}Bu)Ta(=NⁱPr)(NEt₂)(NMeEt), (^{t}BuNC(H)N^{t}Bu)Ta(=NⁱPr)(NEt₂)(NMeEt), (^{t}BuNC(Me)N^{t}Bu)Ta(=NⁱPr)(NEt₂)(NMeEt), (^{t}BuNC(Et)N^{t}Bu)Ta(=NⁱPr)(NEt₂)(NMeEt), (^{t}BuNC(ⁱPr)N^{t}Bu)Ta(=NⁱPr)(NEt₂)(NMeEt), (^{t}BuNC(^{t}Bu)N^{t}Bu)Ta(=NⁱPr)(NEt₂)(NMeEt), (MeNC(H)NMe)Ta(=N^{t}Bu)(NMe₂)₂, (MeNC(H)NEt)Ta(=N^{t}Bᵤ)(NMe₂)₂, (MeNC(H)NⁱPr)Ta(=N^{t}Bu)(NMe₂)₂, (MeNC(H)N^{t}Bu)Ta(=N^{t}Bu)(NMe₂)₂, (MeNC(Me)NMe)Ta(=N^{t}Bu)(NMe₂)₂, (MeNC(Me)NEt)Ta(=N^{t}Bu)(NMe₂)₂, (MeNC(Me)NⁱPr)Ta(=N^{t}Bu)(NMe₂)₂, (MeNC(Me)N^{t}Bu)Ta(=N^{t}Bᵤ)(NMe₂)₂, (MeNC(Et)NMe)Ta(=N^{t}Bu)(NMe₂)₂, (MeNC(Et)NEt)Ta(=N^{t}Bᵤ)(NMe₂)₂, (MeNC(Et)NⁱPr)Ta(=N^{t}Bu)(NMe₂)₂, (MeNC(Et)N^{t}Bu)Ta(=N^{t}Bu)(NMe₂)₂, (MeNC(ⁱPr)NMe)Ta(=N^{t}Bu)(NMe₂)₂, (MeNC(ⁱPr)NEt)Ta(=N^{t}Bu)(NMe₂)₂, (MeNC(ⁱPr)NⁱPr)Ta(=N^{t}Bu)(NMe₂)₂, (MeNC(ⁱPr)N^{t}Bu)Ta(=N^{t}Bu)(NMe₂)₂, (MeNC(^{t}Bu)NMe)Ta(=N^{t}Bu)(NMe₂)₂, (MeNC(^{t}Bu)NEt)Ta(=N^{t}Bu)(NMe₂)₂, (MeNC(^{t}Bu)NⁱPr)Ta(=N^{t}Bu)(NMe₂)₂, (MeNC(^{t}Bu)N^{t}Bu)Ta(=N^{t}Bu)(NMe₂)₂, (EtNC(H)NEt)Ta(=N^{t}Bu)(NMe₂)₂, (EtNC(H)NⁱPr)Ta(=N^{t}Bu)(NMe₂)₂, (EtNC(H)N^{t}Bu)Ta(=N^{t}Bu)(NMe₂)₂, (EtNC(Me)NEt)Ta(=N^{t}Bu)(NMe₂)₂, (EtNC(Me)NⁱPr)Ta(=N^{t}Bu)(NMe₂)₂, (EtNC(Me)N^{t}Bu)Ta(=N^{t}Bu)(NMe₂)₂, (EtNC(Et)NEt)Ta(=N^{t}Bu)(NMe₂)₂, (EtNC(Et)NⁱPr)Ta(=N^{t}Bu)(NMe₂)₂, (EtNC(Et)N^{t}Bu)Ta(=N^{t}Bu)(NMe₂)₂, (EtNC(ⁱPr)NEt)Ta(=N^{t}Bu)(NMe₂)₂, (EtNC(ⁱPr)NⁱPr)Ta(=N^{t}Bu)(NMe₂)₂, (EtNC(ⁱPr)N^{t}Bu)Ta(=N^{t}Bu)(NMe₂)₂, (EtNC(^{t}Bu)NEt)Ta(=N^{t}Bu)(NMe₂)₂, (EtNC(^{t}Bu)NⁱPr)Ta(=N^{t}Bu)(NMe₂)₂, (EtNC(^{t}Bu)N^{t}Bu)Ta(=N^{t}Bu)(NMe₂)₂, (ⁱPrNC(H)NⁱPr)Ta(=N^{t}Bu)(NMe₂)₂, (ⁱPrNC(H)N^{t}Bu)Ta(=N^{t}Bu)(NMe₂)₂, (ⁱPrNC(Me)NⁱPr)Ta(=N^{t}Bu)(NMe₂)₂, (ⁱPrNC(Me)N^{t}Bu)Ta(=N^{t}Bu)(NMe₂)₂, (ⁱPrNC(Et)NⁱPr)Ta(=N^{t}Bu)(NMe₂)₂, (ⁱPrNC(Et)N^{t}Bu)Ta(=N^{t}Bu)(NMe₂)₂, (ⁱPrNC(ⁱPr)NⁱPr)Ta(=N^{t}Bu)(NMe₂)₂, (ⁱPrNC(ⁱPr)N^{t}Bu)Ta(=N^{t}Bu)(NMe₂)₂, (ⁱPrNC(^{t}Bu)NⁱPr)Ta(=N^{t}Bu)(NMe₂)₂, (ⁱPrNC(^{t}Bu)N^{t}Bu)Ta(=N^{t}Bu)(NMe₂)₂, (^{t}BuNC(H)N^{t}Bu)Ta(=N^{t}Bu)(NMe₂)₂, (^{t}BuNC(Me)N^{t}Bu)Ta(=N^{t}Bu)(NMe₂)₂, (^{t}BuNC(Et)N^{t}Bu)Ta(=N^{t}Bu)(NMe₂)₂, (^{t}BuNC(ⁱPr)N^{t}Bu)Ta(=N^{t}Bu)(NMe₂)₂, (^{t}BuNC(^{t}Bu)N^{t}Bu)Ta(=N^{t}Bu)(NMe₂)₂, (MeNC(H)NMe)Ta(=N^{t}Bu)(NMe₂)(NMeEt), (MeNC(H)NEt)Ta(=N^{t}Bu)(NMe₂)(NMeEt), (MeNC(H)NⁱPr)Ta(=N^{t}Bu)(NMe₂)(NMeEt), (MeNC(H)N^{t}Bu)Ta(=N^{t}Bu)(NMe₂)(NMeEt), (MeNC(Me)NMe)Ta(=N^{t}Bu)(NMe₂)(NMeEt), (MeNC(Me)NEt)Ta(=N^{t}Bu)(NMe₂)(NMeEt), (MeNC(Me)NⁱPr)Ta(=N^{t}Bu)(NMe₂)(NMeEt), (MeNC(Me)N^{t}Bu)Ta(=N^{t}Bu)(NMe₂)(NMeEt), (MeNC(Et)NMe)Ta(=N^{t}Bu)(NMe₂)(NMeEt), (MeNC(Et)NEt)Ta(=N^{t}Bu)(NMe₂)(NMeEt), (MeNC(Et)NⁱPr)Ta(=N^{t}Bu)(NMe₂)(NMeEt), (MeNC(Et)N^{t}Bu)Ta(=NtB^{u})(NMe₂)(NMeEt), (MeNC(ⁱPr)NMe)Ta(=N^{t}Bu)(NMe₂)(NMeEt), (MeNC(ⁱPr)NEt)Ta(=N^{t}Bu)(NMe₂)(NMeEt), (MeNC(ⁱPr)NⁱPr)Ta(=N^{t}Bu)(NMe₂)(NMeEt), (MeNC(ⁱPr)N^{t}Bu)Ta(=N^{t}Bu)(NMe₂)(NMeEt), (MeNC(^{t}Bu)NMe)Ta(=N^{t}Bu)(NMe₂)(NMeEt), (MeNC(^{t}Bu)NEt)Ta(=N^{t}Bu)(NMe₂)(NMeEt), (MeNC(^{t}Bu)NⁱPr)Ta(=N^{t}Bu)(NMe₂)(NMeEt), (MeNC(^{t}Bu)N^{t}Bu)Ta(=N^{t}Bu)(NMe₂)(NMeEt), (EtNC(H)NEt)Ta(=N^{t}Bu)(NMe₂)(NMeEt), (EtNC(H)NⁱPr)Ta(=N^{t}Bu)(NMe₂)(NMeEt), (EtNC(H)N^{t}Bu)Ta(=N^{t}Bu)(NMe₂)(NMeEt), (EtNC(Me)NEt)Ta(=N^{t}Bu)(NMe₂)(NMeEt), (EtNC(Me)NⁱPr)Ta(=N^{t}Bu)(NMe₂)(NMeEt), (EtNC(Me)N^{t}Bu)Ta(=N^{t}Bu)(NMe₂)(NMeEt), (EtNC(Et)NEt)Ta(=N^{t}Bu)(NMe₂)(NMeEt), (EtNC(Et)NⁱPr)Ta(=N^{t}Bu)(NMe₂)(NMeEt), (EtNC(Et)N^{t}Bu)Ta(=N^{t}Bu)(NMe₂)(NMeEt), (EtNC(ⁱPr)NEt)Ta(=N^{t}Bu)(NMe₂)(NMeEt), (EtNC(ⁱPr)NⁱPr)Ta(=N^{t}Bu)(NMe₂)(NMeEt), (EtNC(ⁱPr)N^{t}Bu)Ta(=N^{t}Bu)(NMe₂)(NMeEt), (EtNC(^{t}Bu)NEt)Ta(=N^{t}Bu)(NMe₂)(NMeEt), (EtNC(^{t}Bu)NⁱPr)Ta(=N^{t}Bu)(NMe₂)(NMeEt), (EtNC(^{t}Bu)N^{t}Bu)Ta(=N^{t}Bu)(NMe₂)(NMeEt), (ⁱPrNC(H)NⁱPr)Ta(=N^{t}Bu)(NMe₂)(NMeEt), (ⁱPrNC(H)N^{t}Bu)Ta(=N^{t}Bu)(NMe₂)(NMeEt), (ⁱPrNC(Me)NⁱPr)Ta(=N^{t}Bu)(NMe₂)(NMeEt), (ⁱPrNC(Me)N^{t}Bu)Ta(=N^{t}Bu)(NMe₂)(NMeEt), (ⁱPrNC(Et)NⁱPr)Ta(=N^{t}Bu)(NMe₂)(NMeEt), (ⁱPrNC(Et)N^{t}Bu)Ta(=N^{t}Bu)(NMe₂)(NMeEt), (ⁱPrNC(ⁱPr)NⁱPr)Ta(=N^{t}Bu)(NMe₂)(NMeEt), (ⁱPrNC(ⁱPr)N^{t}Bu)Ta(=N^{t}Bu)(NMe₂)(NMeEt), (ⁱPrNC(^{t}Bu)NⁱPr)Ta(=N^{t}Bu)(NMe₂)(NMeEt), (ⁱPrNC(^{t}Bu)N^{t}Bu)Ta(=N^{t}Bu)(NMe₂)(NMeEt), (^{t}BuNC(H)N^{t}Bu)Ta(=N^{t}Bu)(NMe₂)(NMeEt), (^{t}BuNC(Me)N^{t}Bu)Ta(=N^{t}Bu)(NMe₂)(NMeEt), (^{t}BuNC(Et)N^{t}Bu)Ta(=N^{t}Bu)(NMe₂)(NMeEt), (^{t}BuNC(ⁱPr)N^{t}Bu)Ta(=N^{t}Bu)(NMe₂)(NMeEt), (^{t}BuNC(^{t}Bu)N^{t}Bu)Ta(=N^{t}Bu)(NMe₂)(NMeEt), (MeNC(H)NMe)Ta(=N^{t}Bu)(NEt₂)₂, (MeNC(H)NEt)Ta(=N^{t}Bu)(NEt₂)₂, (MeNC(H)NⁱPr)Ta(=N^{t}Bu)(NEt₂)₂, (MeNC(H)N^{t}Bu)Ta(=N^{t}Bu)(NEt₂)₂, (MeNC(Me)NMe)Ta(=N^{t}Bu)(NEt₂)₂, (MeNC(Me)NEt)Ta(=N^{t}Bu)(NEt₂)₂, (MeNC(Me)NⁱPr)Ta(=N^{t}Bu)(NEt₂)₂, (MeNC(Me)N^{t}Bu)Ta(=N^{t}Bu)(NEt₂)₂, (MeNC(Et)NMe)Ta(=N^{t}Bu)(NEt₂)₂, (MeNC(Et)NEt)Ta(=N^{t}Bu)(NEt₂)₂, (MeNC(Et)NⁱPr)Ta(=N^{t}Bu)(NEt₂)₂, (MeNC(Et)N^{t}Bu)Ta(=N^{t}Bu)(NEt₂)₂, (MeNC(ⁱPr)NMe)Ta(=N^{t}Bu)(NEt₂)₂, (MeNC(ⁱPr)NEt)Ta(=N^{t}Bu)(NEt₂)₂, (MeNC(ⁱPr)NⁱPr)Ta(=N^{t}Bu)(NEt₂)₂, (MeNC(ⁱPr)N^{t}Bu)Ta(=N^{t}Bᵤ)(NEt₂)₂, (MeNC(^{t}Bu)NMe)Ta(=N^{t}Bu)(NEt₂)₂, (MeNC(^{t}Bu)NEt)Ta(=N^{t}Bu)(NEt₂)₂, (MeNC(^{t}Bu)NⁱPr)Ta(=N^{t}Bu)(NEt₂)₂, (MeNC(^{t}Bu)N^{t}Bu)Ta(=N^{t}Bu)(NEt₂)₂, (EtNC(H)NEt)Ta(=N^{t}Bu)(NEt₂)₂, (EtNC(H)NⁱPr)Ta(=N^{t}Bu)(NEt₂)₂, (EtNC(H)N^{t}Bu)Ta(=N^{t}Bu)(NEt₂)₂, (EtNC(Me)NEt)Ta(=N^{t}Bu)(NEt₂)₂, (EtNC(Me)NⁱPr)Ta(=N^{t}Bu)(NEt₂)₂, (EtNC(Me)N^{t}Bu)Ta(=N^{t}Bu)(NEt₂)₂, (EtNC(Et)NEt)Ta(=N^{t}Bu)(NEt₂)₂, (EtNC(Et)NⁱPr)Ta(=N^{t}Bu)(NEt₂)₂, (EtNC(Et)N^{t}Bu)Ta(=N^{t}Bu)(NEt₂)₂, (EtNC(ⁱPr)NEt)Ta(=N^{t}Bu)(NEt₂)₂, (EtNC(ⁱPr)NⁱPr)Ta(=N^{t}Bu)(NEt₂)₂, (EtNC(ⁱPr)N^{t}Bu)Ta(=N^{t}Bu)(NEt₂)₂, (EtNC(^{t}Bu)NEt)Ta(=N^{t}Bu)(NEt₂)₂, (EtNC(^{t}Bu)NⁱPr)Ta(=N^{t}Bu)(NEt₂)₂, (EtNC(^{t}Bu)N^{t}Bu)Ta(=N^{t}Bu)(NEt₂)₂, (ⁱPrNC(H)NⁱPr)Ta(=N^{t}Bu)(NEt₂)₂, (ⁱPrNC(H)N^{t}Bu)Ta(=N^{t}Bu)(NEt₂)₂, (ⁱPrNC(Me)NⁱPr)Ta(=N^{t}Bu)(NEt₂)₂, (ⁱPrNC(Me)N^{t}Bu)Ta(=N^{t}Bu)(NEt₂)₂, (ⁱPrNC(Et)NⁱPr)Ta(=N^{t}Bu)(NEt₂)₂, (ⁱPrNC(Et)N^{t}Bu)Ta(=N^{t}Bu)(NEt₂)₂, (ⁱPrNC(ⁱPr)NⁱPr)Ta(=N^{t}Bu)(NEt₂)₂, (ⁱPrNC(ⁱPr)N^{t}Bu)Ta(=N^{t}Bu)(NEt₂)₂, (ⁱPrNC(^{t}Bu)NⁱPr)Ta(=N^{t}Bu)(NEt₂)₂, (ⁱPrNC(^{t}Bu)N^{t}Bu)Ta(=N^{t}Bu)(NEt₂)₂, (^{t}BuNC(H)N^{t}Bu)Ta(=N^{t}Bu)(NEt₂)₂, (^{t}BuNC(Me)N^{t}Bu)Ta(=N^{t}Bu)(NEt₂)₂, (^{t}BuNC(Et)N^{t}Bu)Ta(=N^{t}Bu)(NEt₂)₂, (^{t}BuNC(ⁱPr)N^{t}Bu)Ta(=N^{t}Bu)(NEt₂)₂, (^{t}BuNC(^{t}Bu)N^{t}Bu)Ta(=N^{t}Bu)(NEt₂)₂, (MeNC(H)NMe)Ta(=N^{t}Bu)(NMeEt)₂, (MeNC(H)NEt)Ta(=N^{t}Bu)(NMeEt)₂, (MeNC(H)NⁱPr)Ta(=N^{t}Bu)(NMeEt)₂, (MeNC(H)N^{t}Bu)Ta(=N^{t}Bu)(NMeEt)₂, (MeNC(Me)NMe)Ta(=N^{t}Bu)(NMeEt)₂, (MeNC(Me)NEt)Ta(=N^{t}Bu)(NMeEt)₂, (MeNC(Me)NⁱPr)Ta(=N^{t}Bu)(NMeEt)₂, (MeNC(Me)N^{t}Bu)Ta(=N^{t}Bu)(NMeEt)₂, (MeNC(Et)NMe)Ta(=N^{t}Bu)(NMeEt)₂, (MeNC(Et)NEt)Ta(=N^{t}Bu)(NMeEt)₂, (MeNC(Et)NⁱPr)Ta(=N^{t}Bu)(NMeEt)₂, (MeNC(Et)N^{t}Bu)Ta(=N^{t}Bu)(NMeEt)₂, (MeNC(ⁱPr)NMe)Ta(=N^{t}Bu)(NMeEt)₂, (MeNC(ⁱPr)NEt)Ta(=N^{t}Bu)(NMeEt)₂, (MeNC(ⁱPr)NⁱPr)Ta(=N^{t}Bu)(NMeEt)₂, (MeNC(ⁱPr)N^{t}Bu)Ta(=N^{t}Bu)(NMeEt)₂, (MeNC(^{t}Bu)NMe)Ta(=N^{t}Bu)(NMeEt)₂, (MeNC(^{t}Bu)NEt)Ta(=N^{t}Bu)(NMeEt)₂, (MeNC(^{t}Bu)NⁱPr)Ta(=N^{t}Bu)(NMeEt)₂, (MeNC(^{t}Bu)N^{t}Bu)Ta(=N^{t}Bu)(NMeEt)₂, (EtNC(H)NEt)Ta(=N^{t}Bu)(NMeEt)₂, (EtNC(H)NⁱPr)Ta(=N^{t}Bu)(NMeEt)₂, (EtNC(H)N^{t}Bu)Ta(=N^{t}Bu)(NMeEt)₂, (EtNC(Me)NEt)Ta(=N^{t}Bu)(NMeEt)₂, (EtNC(Me)NⁱPr)Ta(=N^{t}Bu)(NMeEt)₂, (EtNC(Me)N^{t}Bu)Ta(=N^{t}Bu)(NMeEt)₂, (EtNC(Et)NEt)Ta(=N^{t}Bu)(NMeEt)₂, (EtNC(Et)NⁱPr)Ta(=N^{t}Bu)(NMeEt)₂, (EtNC(Et)N^{t}Bu)Ta(=N^{t}Bu)(NMeEt)₂, (EtNC(ⁱPr)NEt)Ta(=N^{t}Bu)(NMeEt)₂, (EtNC(ⁱPr)NⁱPr)Ta(=N^{t}Bu)(NMeEt)₂, (EtNC(ⁱPr)N^{t}Bu)Ta(=N^{t}Bu)(NMeEt)₂, (EtNC(^{t}Bu)NEt)Ta(=N^{t}Bu)(NMeEt)₂, (EtNC(^{t}Bu)NⁱPr)Ta(=N^{t}Bu)(NMeEt)₂, (EtNC(^{t}Bu)N^{t}Bu)Ta(=N^{t}Bu)(NMeEt)₂, (ⁱPrNC(H)NⁱPr)Ta(=N^{t}Bu)(NMeEt)₂, (ⁱPrNC(H)N^{t}Bu)Ta(=N^{t}Bu)(NMeEt)₂, (ⁱPrNC(Me)NⁱPr)Ta(=N^{t}Bu)(NMeEt)₂, (ⁱPrNC(Me)N^{t}Bu)Ta(=N^{t}Bu)(NMeEt)₂, (ⁱPrNC(Et)NⁱPr)Ta(=N^{t}Bu)(NMeEt)₂, (ⁱPrNC(Et)N^{t}Bu)Ta(=N^{t}Bu)(NMeEt)₂, (ⁱPrNC(ⁱPr)NⁱPr)Ta(=N^{t}Bu)(NMeEt)₂, (ⁱPrNC(ⁱPr)N^{t}Bu)Ta(=N^{t}Bu)(NMeEt)₂, (ⁱPrNC(^{t}Bu)NⁱPr)Ta(=N^{t}Bu)(NMeEt)₂, (ⁱPrNC(^{t}Bu)N^{t}Bu)Ta(=N^{t}Bu)(NMeEt)₂, (^{t}BuNC(H)N^{t}Bu)Ta(=N^{t}Bu)(NMeEt)₂, (^{t}BuNC(Me)N^{t}Bu)Ta(=N^{t}Bu)(NMeEt)₂, (^{t}BuNC(Et)N^{t}Bu)Ta(=N^{t}Bu)(NMeEt)₂, (^{t}BuNC(ⁱPr)N^{t}Bu)Ta(=N^{t}Bu)(NMeEt)₂, (^{t}BuNC(^{t}Bu)N^{t}Bu)Ta(=N^{t}Bu)(NMeEt)₂, (MeNC(H)NMe)Ta(=N^{t}Bu)(NEt₂)(NMeEt), (MeNC(H)NEt)Ta(=N^{t}Bu)(NEt₂)(NMeEt), (MeNC(H)NⁱPr)Ta(=N^{t}Bu)(NEt₂)(NMeEt), (MeNC(H)N^{t}Bu)Ta(=N^{t}Bu)(NEt₂)(NMeEt), (MeNC(Me)NMe)Ta(=N^{t}Bu)(NEt₂)(NMeEt), (MeNC(Me)NEt)Ta(=N^{t}Bu)(NEt₂)(NMeEt), (MeNC(Me)NⁱPr)Ta(=N^{t}Bu)(NEt₂)(NMeEt), (MeNC(Me)N^{t}Bu)Ta(=N^{t}Bu)(NEt₂)(NMeEt), (MeNC(Et)NMe)Ta(=N^{t}Bu)(NEt₂)(NMeEt), (MeNC(Et)NEt)Ta(=N^{t}Bu)(NEt₂)(NMeEt), (MeNC(Et)NⁱPr)Ta(=N^{t}Bu)(NEt₂)(NMeEt), (MeNC(Et)N^{t}Bu)Ta(=N^{t}Bu)(NEt₂)(NMeEt), (MeNC(ⁱPr)NMe)Ta(=N^{t}Bu)(NEt₂)(NMeEt), (MeNC(ⁱPr)NEt)Ta(=N^{t}Bu)(NEt₂)(NMeEt), (MeNC(ⁱPr)NⁱPr)Ta(=N^{t}Bu)(NEt₂)(NMeEt), (MeNC(ⁱPr)N^{t}Bu)Ta(=N^{t}Bu)(NEt₂)(NMeEt), (MeNC(^{t}Bu)NMe)Ta(=N^{t}Bu)(NEt₂)(NMeEt), (MeNC(^{t}Bu)NEt)Ta(=N^{t}Bu)(NEt₂)(NMeEt), (MeNC(^{t}Bu)NⁱPr)Ta(=N^{t}Bu)(NEt₂)(NMeEt), (MeNC(^{t}Bu)N^{t}Bu)Ta(=N^{t}Bu)(NEt₂)(NMeEt), (EtNC(H)NEt)Ta(=N^{t}Bu)(NEt₂)(NMeEt), (EtNC(H)NⁱPr)Ta(=N^{t}Bu)(NEt₂)(NMeEt), (EtNC(H)N^{t}Bu)Ta(=N^{t}Bu)(NEt₂)(NMeEt), (EtNC(Me)NEt)Ta(=N^{t}Bu)(NEt₂)(NMeEt), (EtNC(Me)NⁱPr)Ta(=N^{t}Bu)(NEt₂)(NMeEt), (EtNC(Me)N^{t}Bu)Ta(=N^{t}Bu)(NEt₂)(NMeEt), (EtNC(Et)NEt)Ta(=N^{t}Bu)(NEt₂)(NMeEt), (EtNC(Et)NⁱPr)Ta(=N^{t}Bu)(NEt₂)(NMeEt), (EtNC(Et)N^{t}Bu)Ta(=N^{t}Bu)(NEt₂)(NMeEt), (EtNC(ⁱPr)NEt)Ta(=N^{t}Bu)(NEt₂)(NMeEt), (EtNC(ⁱPr)NⁱPr)Ta(=N^{t}Bu)(NEt₂)(NMeEt), (EtNC(ⁱPr)N^{t}Bu)Ta(=N^{t}Bu)(NEt₂)(NMeEt), (EtNC(^{t}Bu)NEt)Ta(=N^{t}Bu)(NEt₂)(NMeEt), (EtNC(^{t}Bu)NⁱPr)Ta(=N^{t}Bu)(NEt₂)(NMeEt), (EtNC(^{t}Bu)N^{t}Bu)Ta(=N^{t}Bu)(NEt₂)(NMeEt), (ⁱPrNC(H)NⁱPr)Ta(=N^{t}Bu)(NEt₂)(NMeEt), (ⁱPrNC(H)N^{t}Bu)Ta(=N^{t}Bu)(NEt₂)(NMeEt), (ⁱPrNC(Me)NⁱPr)Ta(=N^{t}Bu)(NEt₂)(NMeEt), (ⁱPrNC(Me)N^{t}Bu)Ta(=N^{t}Bu)(NEt₂)(NMeEt), (ⁱPrNC(Et)NⁱPr)Ta(=N^{t}Bu)(NEt₂)(NMeEt), (ⁱPrNC(Et)N^{t}Bu)Ta(=N^{t}Bu)(NEt₂)(NMeEt), (ⁱPrNC(ⁱPr)NⁱPr)Ta(=N^{t}Bu)(NEt₂)(NMeEt), (ⁱPrNC(ⁱPr)N^{t}Bu)Ta(=N^{t}Bu)(NEt₂)(NMeEt), (ⁱPrNC(^{t}Bu)NⁱPr)Ta(=N^{t}Bu)(NEt₂)(NMeEt), (ⁱPrNC(^{t}Bu)N^{t}Bu)Ta(=N^{t}Bu)(NEt₂)(NMeEt), (^{t}BuNC(H)N^{t}Bu)Ta(=N^{t}Bᵤ)(NEt₂)(NMeEt), (^{t}BuNC(Me)N^{t}Bu)Ta(=N^{t}Bu)(NEt₂)(NMeEt), (^{t}BuNC(Et)N^{t}Bu)Ta(=N^{t}Bu)(NEt₂)(NMeEt), (^{t}BuNC(ⁱPr)N^{t}Bu)Ta(=N^{t}Bu)(NEt₂)(NMeEt), (^{t}BuNC(^{t}Bu)N^{t}Bu)Ta(=N^{t}Bu)(NEt₂)(NMeEt), (MeNC(H)NMe)Ta(=N^{t}Bu)(NMe₂)(NEt₂), (MeNC(H)NEt)Ta(=N^{t}Bu)(NMe₂)(NEt₂), (MeNC(H)NⁱPr)Ta(=N^{t}Bu)(NMe₂)(NEt₂), (MeNC(H)N^{t}Bu)Ta(=N^{t}Bu)(NMe₂)(NEt₂), (MeNC(Me)NMe)Ta(=N^{t}Bu)(NMe₂)(NEt₂), (MeNC(Me)NEt)Ta(=N^{t}Bu)(NMe₂)(NEt₂), (MeNC(Me)NⁱPr)Ta(=N^{t}Bu)(NMe₂)(NEₜ2), (MeNC(Me)N^{t}Bu)Ta(=N^{t}Bu)(NMe₂)(NEt₂), (MeNC(Et)NMe)Ta(=N^{t}Bu)(NMe₂)(NEt₂), (MeNC(Et)NEt)Ta(=N^{t}Bu)(NMe₂)(NEt₂), (MeNC(Et)NⁱPr)Ta(=N^{t}Bu)(NMe₂)(NEt₂), (MeNC(Et)N^{t}Bu)Ta(=N^{t}Bu)(NMe₂)(NEt₂), (MeNC(ⁱPr)NMe)Ta(=N^{t}Bu)(NMe₂)(NEt₂), (MeNC(ⁱPr)NEt)Ta(=N^{t}Bu)(NMe₂)(NEt₂), (MeNC(ⁱPr)NⁱPr)Ta(=N^{t}Bu)(NMe₂)(NEt₂), (MeNC(ⁱPr)N^{t}Bu)Ta(=N^{t}Bu)(NMe₂)(NEₜ2), (MeNC(^{t}Bu)NMe)Ta(=N^{t}Bu)(NMe₂)(NEt₂), (MeNC(^{t}Bu)NEt)Ta(=N^{t}Bu)(NMe₂)(NEt₂), (MeNC(^{t}Bu)NⁱPr)Ta(=N^{t}Bu)(NMe₂)(NEₜ2), (MeNC(^{t}Bu)N^{t}Bu)Ta(=N^{t}Bu)(NMe₂)(NEt₂), (EtNC(H)NEt)Ta(=N^{t}Bu)(NMe₂)(NEt₂), (EtNC(H)NⁱPr)Ta(=N^{t}Bu)(NMe₂)(NEt₂), (EtNC(H)N^{t}Bu)Ta(=N^{t}Bu)(NMe₂)(NEt₂), (EtNC(Me)NEt)Ta(=N^{t}Bu)(NMe₂)(NEt₂), (EtNC(Me)NⁱPr)Ta(=N^{t}Bu)(NMe₂)(NEt₂), (EtNC(Me)N^{t}Bu)Ta(=N^{t}Bu)(NMe₂)(NEt₂), (EtNC(Et)NEt)Ta(=N^{t}Bu)(NMe₂)(NEt₂), (EtNC(Et)NⁱPr)Ta(=N^{t}Bu)(NMe₂)(NEt₂), (EtNC(Et)N^{t}Bu)Ta(=N^{t}Bu)(NMe₂)(NEt₂), (EtNC(ⁱPr)NEt)Ta(=N^{t}Bu)(NMe₂)(NEt₂), (EtNC(ⁱPr)NⁱPr)Ta(=N^{t}Bu)(NMe₂)(NEt₂), (EtNC(ⁱPr)N^{t}Bu)Ta(=N^{t}Bu)(NMe₂)(NEt₂), (EtNC(^{t}Bu)NEt)Ta(=N^{t}Bu)(NMe₂)(NEt₂), (EtNC(^{t}Bu)NⁱPr)Ta(=N^{t}Bu)(NMe₂)(NEt₂), (EtNC(^{t}Bu)N^{t}Bu)Ta(=N^{t}Bu)(NMe₂)(NEt₂), (ⁱPrNC(H)NⁱPr)Ta(=N^{t}Bu)(NMe₂)(NEt₂), (ⁱPrNC(H)N^{t}Bu)Ta(=N^{t}Bu)(NMe₂)(NEt₂), (ⁱPrNC(Me)NⁱPr)Ta(=N^{t}Bu)(NMe₂)(NEt₂), (ⁱPrNC(Me)N^{t}Bu)Ta(=N^{t}Bu)(NMe₂)(NEt₂), (ⁱPrNC(Et)NⁱPr)Ta(=N^{t}Bu)(NMe₂)(NEt₂), (ⁱPrNC(Et)N^{t}Bu)Ta(=N^{t}Bu)(NMe₂)(NEt₂), (ⁱPrNC(ⁱPr)NⁱPr)Ta(=N^{t}Bu)(NMe₂)(NEt₂), (ⁱPrNC(ⁱPr)N^{t}Bu)Ta(=N^{t}Bu)(NMe₂)(NEt₂), (ⁱPrNC(^{t}Bu)NⁱPr)Ta(=N^{t}Bu)(NMe₂)(NEt₂), (ⁱPrNC(^{t}Bu)N^{t}Bu)Ta(=N^{t}Bu)(NMe₂)(NEt₂), (^{t}BuNC(H)N^{t}Bu)Ta(=N^{t}Bu)(NMe₂)(NEt₂), (^{t}BuNC(Me)N^{t}Bu)Ta(=N^{t}Bu)(NMe₂)(NEt₂), (^{t}BuNC(Et)N^{t}Bu)Ta(=N^{t}Bu)(NMe₂)(NEt₂), (^{t}BuNC(ⁱPr)N^{t}Bu)Ta(=N^{t}Bu)(NMe₂)(NEt₂), (^{t}BuNC(^{t}Bᵤ)N^{t}Bu)Ta(=N^{t}Bᵤ)(NMe₂)(NEt₂),

### Example 2: Synthesis of (ⁱPrNC(CH₃)NHPrⁱ)Ta(=N^{t}Bu)(NEt₂)₂

All manipulations are performed under an inert atmosphere of dry oxygen-free argon by means of standard Schlenk or glovebox techniques. ^{t}BuN=Ta(NEt₂)₃ (1.51g, 3.22mmol) is dissolved in 20 ml of dried toluene. The reaction mixture is cooled by an ice bath to 0°C and a mixture of ^{I}PrNC(CH₃)NHⁱPr (0.46g, 3.23mmol) in 10ml of dried toluene is slowly added drope wise resulting in a slightly yellow solution. After the mixture is left at room temperatrure under magnetic stirring one night, stripping of the solvent and volatile components is performed under reduced pressure to afford 1.64g (94.6% of yield based on Ta) of a slightly yellow solid of (ⁱPrNC(CH₃)NPrⁱ)Ta(=N^{t}Bu)(NEt₂)₂.

### Example 3: Thermal behavior of (ⁱPrNC(CH₃)NⁱPr)Ta(=N^{t}Bᵤ)(NEt₂)₂

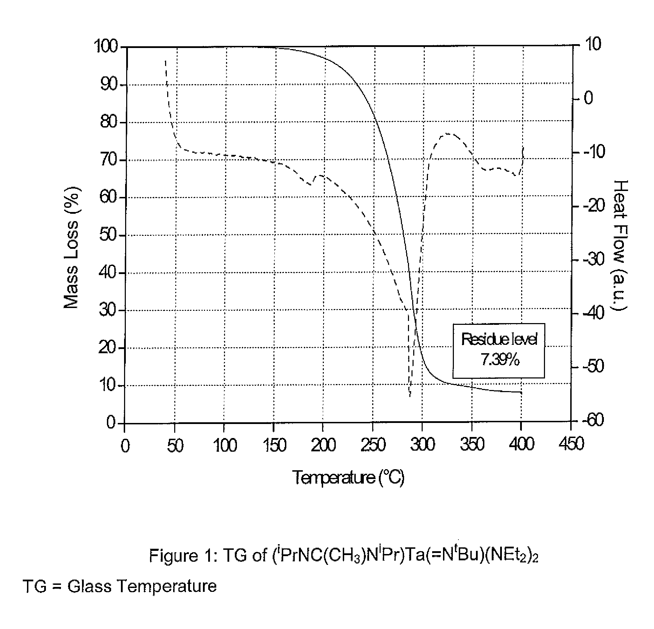

A 53.42mg sample of Ta(ⁱPrNC(CH₃)NⁱPr)(=N^{t}Bu)(NEt₂)₂ is placed in a 4.5mm crucible. The crucible is placed in a thermogravimetric apparatus where it is heated at 10°C/min at atmospheric pressure under a He flow of 30sccm. The mass loss of the sample and the heat flow of the sample are continuously monitored. At the end of the evaporation, the residue level is 7.39%, indicative of very limited thermal decomposition during the evaporation. This thermal behaviour is illustred on figure 1.

### Example 4: MOCVD of TaNₓC_{y} using (ⁱPrNC(CH₃)NⁱPr)Ta(=N^{t}Bu)(NEt₂)₂

(ⁱPrNC(CH₃)NⁱPr)Ta(=N^{t}Bu)(NEt₂)₂ is stored into a container. The container is heated at 90°C and N₂ is used as carrier gas at a flow of 100sccm. The pressure in the container is controlled at 50Torr. (ⁱPrNC(CH₃)NⁱPr)Ta(=N^{t}Bu)(NEt₂)₂ is mixed to a H₂/N₂ gas mixture into the reaction chamber. The substrate is heated at 450°C. The pressure inside the reactor is set at 20Torr. A film of tantalum carbo-nitride is obtained. Similar experiments can be performed with Nb and V analogs.

### Example 5: ALD of TaNₓ using (ⁱPrNC(CH₃)NⁱPr)Ta(=N^{t}Bu)(NEt₂)₂

(ⁱPrNC(CH₃)NⁱPr)Ta(=N^{t}Bu)(NEt₂)₂ is stored into a container. The container is heated at 90°C and N₂ is used as carrier gas at a flow of 100sccm. Ammonia (NH₃) is used as nitrogen source. The substrate is heated at 250°C. The precursor is sequentially introduced into the reaction chamber with NH₃: during the first step a pulse of (ⁱPrNC(CH₃)NⁱPr)Ta(=N^{t}Bu)(NEt₂)₂ is introduced during 2s, followed by a 2s N₂ purge. A pulse of NH₃ is then introduced into the reaction chamber during 2s, followed by a 2s N₂ purge. The first step is then done again. 100cycles are performed this way. A film of tantalum nitride is obtained. Similar experiments can be performed with Nb and V analogs. Those skilled in the art will additionally recognize that the purge and introduction times can be modified.

### Example 6: MOCVD of TaSi using (ⁱPrNC(CH₃)NⁱPr)Ta(=N^{t}Bu)(NEt₂)₂

(ⁱPrNC(CH₃)NⁱPr)Ta(=N^{t}Bu)(NEt₂)₂ is stored into a container. The container is heated at 90°C and N₂ is used as carrier gas at a flow of 100sccm. The pressure in the container is controlled at 50Torr. (ⁱPrNC(CH₃)NⁱPr)Ta(=N^{t}Bu)(NEt₂)₂ is mixed to a SiH₄/N₂ gas mixture into the reaction chamber. The substrate is heated at 400°C. The pressure inside the reaction chamber is set at 20Torr. A film of tantalum silicide is obtained. Similar experiments can be performed with Nb and V analogs.

### Example 7: ALD of TaSi using (ⁱPrNC(CH₃)NⁱPr)Ta(=N^{t}Bu)(NEt₂)₂

(ⁱPrNC(CH₃)NⁱPr)Ta(=N^{t}Bu)(NEt₂)₂ is stored into a container. The container is heated at 90°C and N₂ is used as carrier gas at a flow of 100sccm. A SiH₄/N₂ gas mixture is used as silicium source. The substrate is heated at 250°C. The precursor is sequentially introduced into the reaction chamber with a SiH₄/N₂ gas mixture: during the first step a pulse of (ⁱPrNC(CH₃)NⁱPr)Ta(=N^{t}Bu)(NEt₂)₂ is introduced during 2s, followed by a 2s N₂ purge. A pulse of a SiH₄/N₂ gas mixture is then introduced into the reaction chamber during 2s, followed by a 2s N₂ purge. The first step is then done again. 100cycles are performed this way. A film of tantalum silicide is obtained. Similar experiments can be performed with Nb and V analogs. Similarly, those skilled in the art will additionally recognize that the purge and introduction times can be modified.

### Example 8: MOCVD of Ta₂O₅ using (ⁱPrNC(CH₃)NⁱPr)Ta(=N^{t}Bu)(NEt₂)₂

(ⁱPrNC(CH₃)NHPrⁱ)Ta(=N^{t}Bu)(NEt₂)₂ is stored into a container. The container is heated at 90°C and N₂ is used as carrier gas at a flow of 100sccm. The pressure in the container is controlled at 50Torr. (ⁱPrNC(CH₃)NHPrⁱ)Ta(=N^{t}Bu)(NEt₂)₂ is mixed to an O₂/N₂ gas mixture into the reaction chamber. The substrate is heated at 450°C. The pressure inside the reaction chamber is set at 20Torr. A film of tantalum oxide is obtained. Similar experiments can be performed with Nb and V analogs.

### Example 9: ALD of Ta₂O₅ using (ⁱPrNC(CH₃)NⁱPr)Ta(=N^{t}Bu)(NEt₂)₂

(ⁱPrNC(CH₃)NⁱPr)Ta(=N^{t}Bu)(NEt₂)₂ is stored into a container. The container is heated at 90°C and N₂ is used as carrier gas at a flow of 100sccm. A O₂/N₂ gas mixture is used as oxygen source. The substrate is heated at 300°C. The precursor is sequentially introduced into the reaction chamber with a O₂/N₂ gas mixture: during the first step a pulse of (ⁱPrNC(CH₃)NⁱPr)Ta(=N^{t}Bu)(NEt₂)₂ is introduced during 2s, followed by a 2s N₂ purge. A pulse of a O₂/N₂ gas mixture is then introduced into the reaction chamber during 2s, followed by a 2s N₂ purge. The first step is then done again. 100cycles are performed this way. A film of tantalum oxide is obtained. Similar experiments can be performed with Nb and V analogs.

### Example 10: MOCVD of HfTaOx using (ⁱPrNC(CH₃)NⁱPr)Ta(=N^{t}Bu)(NEt₂)₂ and another Hf precursor

(ⁱPrNC(CH₃)NⁱPr)Ta(=N^{t}Bu)(NEt₂)₂ is stored into a container. The container is heated at 90°C and N₂ is used as carrier gas at a flow of 100sccm. Tetrakis(ethylmethylamino)Hafnium, Hf(NEtMe)₄, is stored in another container, heated at 90°C and a N₂ carrier is passed through this second container at 100sccm. The pressure in both containers is controlled at 50Torr. Both precursors are simultaneously fed into the reaction chamber. A O₂/N₂ gas mixture is simultaneously introduced into the reaction chamber. The substrate is heated at 450°C. The pressure inside the reaction chamber is set at 20Torr. A film of tantalum hafnium oxide is obtained. Similar experiments can be performed with Nb and V analogs.

### Example 11: MOCVD of HfTaOx using (ⁱPrNC(CH₃)NⁱPr)Ta(=N^{t}Bu)(NEt₂)₂ and another Hf precursor

(ⁱPrNC(CH₃)NⁱPr)Ta(=N^{t}Bu)(NEt₂)₂ is stored into a container. The container is heated at 90°C and N2 is used as carrier gas at a flow of 100sccm. Tetrakis(ethylmethylamino)Hafnium, TEMAH, is stored in another container, heated at 90°C and a N₂ carrier is passed through this second container at 100sccm. The pressure in both containers is controlled at 50Torr. O₃ is used as oxygen source. The substrate is heated at 300°C. The precursors are sequentially introduced into the reaction chamber: during the first step a pulse of (ⁱPrNC(CH₃)NⁱPr)Ta(=N^{t}Bu)(NEt₂)₂ is introduced during 2s, followed by a 2s N₂ purge. A pulse of O₃ is then introduced into the reaction chamber during 2s, followed by a 2s N₂ purge. A pulse of TEMAH is then introduced into the reaction chamber during 2s, followed by a 2s N₂ purge. A pulse of O₃ is then introduced into the reaction chamber during 2s. The first step is then done again. 100cycles are performed this way. A film of tantalum hafnium oxide is obtained. Similar experiments can be performed with Nb and V analogs.

## Claims

1. Compound of the formula (I):
(R¹NC(R²)NR³)M(=NR⁴)_{y}[(NR⁵ R⁶)z₁(NR⁷ R⁸) z₂]
wherein,
y is an integer, y ≥ 1,
z₁ and z₂ are integers, z₁ ≥ 0 and z₂ ≥ 0,
and, 2y + z₁ + z₂ = 4;
M is a group V metal selected from Tantalum (Ta), Niobium (Nb) and Vanadium (V),
R¹, R², R³, R⁴, R⁵, R⁶, R⁷, and R⁸ which may be identical or different, are independently chosen from Hydrogen atom, linear or branched alkyl groups having from one to six carbon atoms, linear or branched alkoxy groups having from one to six carbon atoms, linear or branched alkylamide groups having from one to six carbon atoms, linear or branched alkylsilylamide groups having from one to six carbon atoms, linear or branched alkylsilyl groups having from one to six carbon atoms.

2. Compound of the formula (la) : 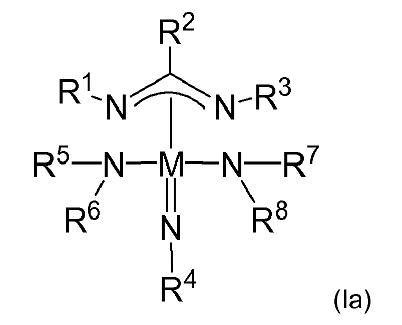 the formula (Ia) corresponding to formula (I) as defined above, wherein y=1 and z₁=z₂=1.

3. Compound of the formula (I) according to claim 1 or to claim 2, wherein R¹ and R³, which may be identical or different, are independently chosen from linear or branched alkyl groups having from one to four carbon atoms.

4. Compound of the formula (I) according to one of claim 1 to claim 3, wherein R¹ and R³, which may be identical or different, are independently chosen between methyl, ethyl, isopropyl and tert-butyl.

5. Compound of the formula (I) according to one of claim 1 to claim 4, wherein R², is chosen from hydrogen and linear or branched alkyl groups having one to three carbon atoms, preferably, R² is chosen between hydrogen and methyl.

6. Compound of the formula (I) according to one of claim 1 to claim 5, wherein R¹, R², and R³, are different from one another.

7. Compound of the formula (I) according to one of claim 1 to claim 6, wherein R⁴ is chosen from linear or branched alkyl groups having three or four carbon atoms, preferably R⁴ is chosen between isopropyl and tert-butyl.

8. Compound of the formula (I) according to one of claim 1 to claim 7, wherein R⁵, R⁶, R⁷, and R⁸, which may be identical or different, are independently chosen from linear or branched alkyl groups having from one to three carbon atoms, preferably between methyl and ethyl.

9. Compound of the formula (I) according to one of claim 1 to claim 8, wherein R⁵, R⁶, R⁷, and R⁸, are different from one another.

10. The following compounds:
(ⁱPrNC(Me)NⁱPr)Ta(=N^{t}Bu)(N Et₂)₂;
(ⁱPrNC(Me)NⁱPr)Ta(=N^{t}Bu)(NMe₂)₂ ;
(ⁱPrNC(Me)NⁱPr)Ta(=NⁱPr)(NEt₂)₂ ;
(ⁱPrNC(Me)NⁱPr)Ta(=NⁱPr)(NMe₂)₂ ;
(ⁱPrNC(H)NⁱPr)Ta(=N^{t}Bu)(NEt₂)₂;
(ⁱPrNC(H)NⁱPr)Ta(=N^{t}Bu)(NMe₂)₂ ;

11. A process for depositing a group V metal containing film on a substrate comprising the steps of:
a. Introducing a substrate into a reactor;
b. Heating the substrate at a temperature preferably above 150°C;
c. Feeding at least one compound of the formula (I) as disclosed in one of Claim 1 to Claim 10, or a mixture of said compound thereof in the vapor phase into the reactor;
d. Optionally feeding at least another compound of the formula (I) as disclosed in one of Claim 1 to Claim 9, or a second mixture of said compounds thereof in vapor phase into the reactor;
e. Depositing a film containing at least one of said compounds of the formula (I), onto said substrate.

12. A process for depositing a TaⱼXᵢX'ₖ layer on a substrate, according to Claim 11, j is an integer equal to 1 or 2, i and k are integers comprised between 0 and 5, X and X' being selected from N and O, further comprising the step of injecting a X comprising reactant and/or a X' comprising reactant, the metal source and reactant species can be introduced simultaneously, sequentially or different combinations.

13. A process for depositing a TaY layer on a substrate, according to Claim 11 or Claim 12, Y being selected from Si, Hf, and C, further comprising the step of feeding a Y containing precursor, the metal source and Y containing precursor can be introduced simultaneously, sequentially or different combinations.

14. A process for depositing a TaXY layer on a substrate, according to one of Claim 11 to Claim 13, X being selected from N and O, and Y being selected from Si, Hf, and C, further comprising the step of injecting a X comprising reactant and the step of feeding a Y containing precursor.

15. Use in metal containing film deposition of at least one compound of the formula (I) as disclosed in one of Claim 1 to Claim 10.
